(19) Europäisches Patentamt
European Patent Office
Office européen des brevets

(11) **EP 2 421 148 B1**

(12) **EUROPÄISCHE PATENTSCHRIFT**

(45) Veröffentlichungstag und Bekanntmachung des Hinweises auf die Patenterteilung:
**11.02.2015 Patentblatt 2015/07**

(21) Anmeldenummer: **10172911.9**

(22) Anmeldetag: **16.08.2010**

(51) Int Cl.:
*G01M 10/00* (2006.01)     *G01R 31/34* (2006.01)
*G01M 1/10* (2006.01)      *H02P 21/14* (2006.01)
*H02P 23/14* (2006.01)

(54) **Vorrichtung und Verfahren zur drehgeberlosen Identifikation mechanischer Kenngrößen eines Drehstrom-Asynchronmotors**

Device and method for identifying mechanical parameters of an alternating current asynchronous motor without using a rotary encoder

Dispositif et procédé d'identification des paramètres de référence mécaniques d'un moteur asynchrone triphasé sans utilisation d'encodeur de vitesse

(84) Benannte Vertragsstaaten:
**AL AT BE BG CH CY CZ DE DK EE ES FI FR GB GR HR HU IE IS IT LI LT LU LV MC MK MT NL NO PL PT RO SE SI SK SM TR**

(43) Veröffentlichungstag der Anmeldung:
**22.02.2012 Patentblatt 2012/08**

(73) Patentinhaber: **Baumüller Nürnberg GmbH**
**90482 Nürnberg (DE)**

(72) Erfinder:
• **Villwock, Sebastian**
**95701 Pechbrunn (DE)**
• **Zatocil, Heiko**
**90429, Nürnberg (DE)**

(74) Vertreter: **Götz, Georg Alois**
**Intellectual Property IP-GÖTZ**
**Patent- und Rechtsanwälte**
**Postfach 35 45**
**90017 Nürnberg (DE)**

(56) Entgegenhaltungen:
**KR-A- 20080 062 830**

• **VILLWOCK S ET AL: "Application of the welch-method for the automatic parameter identification of electrical drives", INDUSTRIAL ELECTRONICS SOCIETY, 2005. IECON 2005. 31ST ANNUAL CONFERENCE OF IEEE, IEEE, PISCATAWAY, NJ, USA LNKD- DOI: 10.1109/IECON.2005.1569118, 6. November 2005 (2005-11-06), Seiten 1449-1454, XP010876187, ISBN: 978-0-7803-9252-6**
• **SEBASTIAN VILLWOCK ET AL: "Application of the Welch-Method for the Identification of Two and Three-Mass-Systems", IEEE TRANSACTIONS ON INDUSTRIAL ELECTRONICS, IEEE SERVICE CENTER, PISCATAWAY, NJ, USA, Bd. 54, Nr. 1, 1. Januar 2008 (2008-01-01) , Seiten 457-466, XP011198792, ISSN: 0278-0046**

**Beschreibung**

Die vorliegende Erfindung geht aus von einem Verfahren, einer Einrichtung, einer Vorrichtung und einer Verfahrensverwendung für eine drehgeberlose Identifikation magnetomechanischer Kenngrößen, insbesondere Massenträgheitsmoment $J$ eines Drehstrom-Asynchronmotors. Mechanische Kenngrößen ermöglichen die Charakterisierung eines Drehstrommotors in Bezug auf das mechanische Dynamikverhalten, so dass das mechanisch-rotatorische Verhalten des Motors im Betrieb charakterisiert werden kann.

STAND DER TECHNIK

Aus dem Stand der Technik sind verschiedene Methoden bekannt, um das mechanische Verhalten eines Drehstrommotors zu bestimmen. Aus der KR 2008 0062830 A ist ein Schätzverfahren für das Trägheitsmoment für sensorlose Inverter bekannt. In der Regel wird zur Bestimmung des mechanischen Verhaltens Sensordaten von Positions-, Drehwinkel- oder Drehzahlgebern ausgewertet, und unter Berücksichtigung von mechanischen Strukturdaten des Drehstrommotors das Massenträgheitsmoment $J$ des Rotors bzw. Antriebsstrangs: $J = \int r^2 \rho(\vec{r})dV$ mit $\rho(\vec{r})$ der Massendichte innerhalb des Volumes $V$ mit Abstand $r$ von der Drehachse des Rotors bestimt. Die Massenträgheit $J$ gibt den Widerstand des Rotors bei Änderung seines Rotationszustands an, und beschreibt somit die Drehdynamik des Motors. Aus ihr lässt sich das Drehmoment $M$ mittels $M = \dot{\omega}J = \alpha J$ berechnen. Moderne drehgeberlos geregelte elektrische Antriebe können allerdings nicht auf Sensordaten zurückgreifen, so dass im normalen Betrieb mechanische Kenngrößen nicht ermittelbar sind.

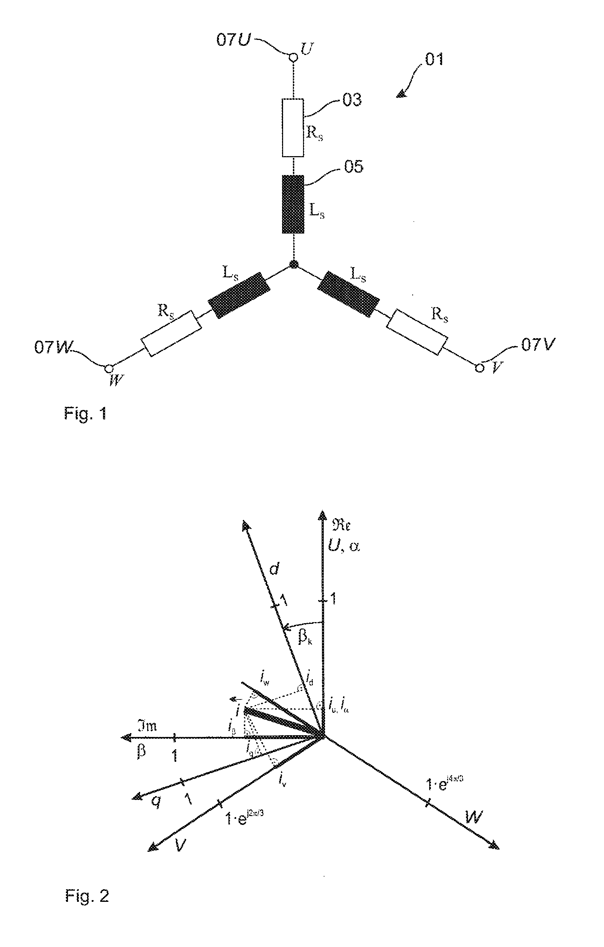

In einem Dreiphasensystem ergibt sich in Y- oder $\Delta$-Schaltung durch Einspeisung zweier Phasen jeweils der Strom der dritten Phase nach der Regel $I_u + I_v + I_w = 0$ bei fehlender Sternpunktserdung. Aus diesem Grund lässt sich ein Dreiphasensystem auch mittels zweier Koordinaten beschreiben, wobei zur Beschreibung des Gesamtstroms ein Koordinatensystem in der komplexen Ebene betrachtet werden kann, bei der die beiden Koordinaten Realteil und Imaginärteil als $\alpha$- und $\beta$-Koordinaten bezüglich der ortsfesten Ausrichtung der Statorwicklungen nach Fig. 1 bezeichnet werden können. Das $\alpha/\beta$-Koordinatensystem beschreibt beispielsweise die Richtung des Stromflusses oder die Rotorflußachse in dem ruhenden Bezugssystems des Stators des Drehstrommotors. Bezüglich der magnetischen Ausrichtung des Läufers kann ein zweites sich drehendes Koordinatensystem eingeführt werden, dessen Achsen als $d$- und q-Achse des Rotors bezeichnet werden, wie es in Fig. 2 dargestellt ist. Die $d$-Achse bezeichnet die Richtung des Läuferflusses und die q-Achse die hierzu rechtwinklige Querflussachse. Eine Transformation von $\alpha/\beta$-Statorkoordinatensystem in das sich drehende $d/q$-Rotorkoordinatensystem kann über den Drehwinkel $\beta_k$ zwischen der Wicklungsachse der Phase $U$ des Stators und der Längsachse des Rotormagnetfeldes hergestellt werden. Diesbezüglich können ein Gesamtmotorstrom $I$, bzw. dessen drei Phasenströme $I_U$, $I_V$ und $I_W$ im statorfesten $\alpha/\beta$-Koordinatensystem oder im sich mit dem Läufer drehenden $d/q$-Koordinatensystem betrachtet werden. Bezüglich der Umrechnung der Strangströme des Drehstrom-Asynchronmotors in das $\alpha/\beta$-Koordinatensystem gilt folgender Zusammenhang:

$$\begin{pmatrix} i_\alpha \\ i_\beta \end{pmatrix} = \begin{pmatrix} 1 & 0 & 0 \\ 0 & \dfrac{\sqrt{3}}{3} & -\dfrac{\sqrt{3}}{3} \end{pmatrix} \begin{pmatrix} i_u \\ i_v \\ i_w \end{pmatrix}, \qquad \begin{pmatrix} i_u \\ i_v \\ i_w \end{pmatrix} = \begin{pmatrix} 1 & 0 \\ -\dfrac{1}{2} & \dfrac{\sqrt{3}}{2} \\ -\dfrac{1}{2} & -\dfrac{\sqrt{3}}{2} \end{pmatrix} \begin{pmatrix} i_\alpha \\ i_\beta \end{pmatrix},$$

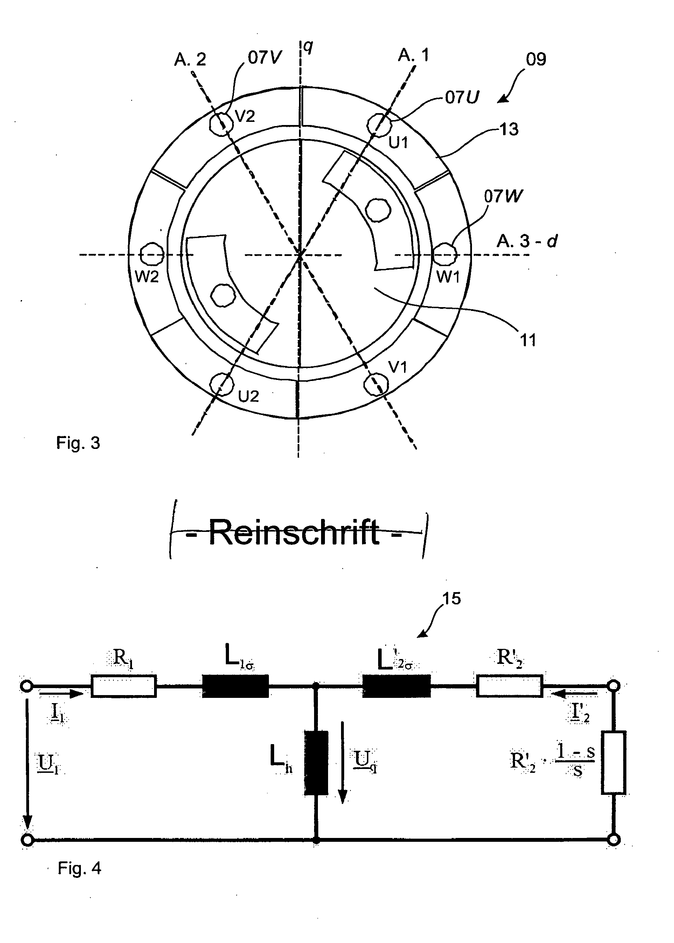

der mittels Berücksichtigung des Läuferflußwinkels $\beta_k$ für das $d/q$-Koordinatensystem modifizierbar ist. Zur nachfolgenden mathematischen Erfassung der Zusammenhänge wird eine Betrachtung im $\alpha/\beta$-Statorkoordinatensystem nach Fig. 2 durchgeführt, wobei das in Fig. 4 dargestellte T-Ersatzschaltbild, eine Ersatzschaltbildcharakterisierung der Drehstrom-Asynchronmaschine in einem einphasigen System mit Speisespannungen-und Ströme $U_1$, $I_1$ sowie $U_2/I_2$ beschreibt.

In der Fig. 4 ist das T-Ersatzschaltbild eines Asynchronmotors bezüglich einer einphasigen Betrachtung dargestellt, wobei unter Kenntnis der genannten Ersatzschaltbildgrößen das elektrische Betriebsverhalten des Drehstrommotors in einem stationären Betriebsfall, d.h. bei konstanter Drehzahl und Belastung abschätzbar wird. Der Parameter s kennzeichnet den Schlupf, d. h. das Nacheilen des drehenden Rotors gegenüber dem rotierenden Statormagnetfeld. Hieraus lassen sich die Relationen zwischen eingespeisten Spannungen und auftretenden Strömen des Motors beschreiben durch :

$$\vec{U}_1^S = R_1 \ \vec{I}_1^S + \frac{d\vec{\Psi}_1^S}{dt} \ \text{mit} \ \vec{\Psi}_1^S = L_1 \ \vec{I}_1^S + L_h \ \vec{I}_2^S \ \text{und} \ L_1 = L_{1\sigma} + L_h,$$

$$\vec{U}_2^S = R_2 \ \vec{I}_2^S + \frac{d\vec{\Psi}_2^S}{dt} - j \ \Omega_L \vec{\Psi}_2^S \ \text{mit} \ \vec{\Psi}_2^S = L_h \ \vec{I}_1^S + L_2 \ \vec{I}_2^S \ \text{und} \ L_2 = L_{2\sigma} + L_h.$$

Die oben genannten Differentialrelationen sind unter der Annahme einer Schlupfgröße s von 1, d.h. Stillstand hergeleitet worden. Eine Parameterbestimmung elektrischer Ersatzschaltbildgrößen im Leerlauf- Kurzschluß- und Gleichstromversuch beruhen auf diesem T-Ersatzschaltbild. Bezüglich einer komplizierteren Betrachtung in einem später dargestellten $\alpha/\beta$ oder $d/q$-Koordinatensystem der Motorspannungen und -ströme können die gleichen Ersatzschaltbildparameter berücksichtigt werden, allerdings erlaubt diese Betrachtungsweise nicht nur eine stationäre Charakterisierung des Motors, sondern ermöglicht eine Beschreibung des dynamischen Verhaltens.

Durch Messung der elektrischen Größen lässt sich die Admittanz des Motors im Betriebsverhalten bestimmen, die sich nach folgender Gleichung ergibt:

$$G_{\alpha/\beta}(j\omega) = Y_{\alpha/\beta}(j\omega) = \frac{I_{1\alpha/\beta}(j\omega)}{U_{1\alpha/\beta}(j\omega)}$$

Ausgehend von den Phasenspannungen $U_U$, $U_V$ und $U_W$ und Strangströmen $I_U$, $I_V$ und $I_W$ werden diese gemäß der obigen Transformation in das $\alpha/\beta$-Koordinatensystem überführt. Somit lässt sich das elektrische Verhalten der Drehstrom-Synchronmaschine mit Hilfe der Eingangsgrößen $U_1$ oder $U_2$ und Ausgangsgrößen $I_1$ oder $I_2$ betrachten. Diesbezüglich lassen sich getrennte Betrachtungsweisen bezüglich der statorfesten $\alpha$ -und $\beta$-Achse durchführen, so dass sich beispielsweise bezüglich der $\beta$-Achse eine Übertragungsfunktion, beziehungsweise Admittanz ergibt mit:

$$G_\beta = I_{1\beta}/U_{1\beta}.$$

Die Bestimmung der Koeffizienten der Übertragungsfunktion $G_\beta$ ermöglicht die Identifikation der zugrundeliegenden Systemparameter, beispielsweise von elektrischen Ersatzschaltbildgrößen. Es gibt beispielsweise parallele Überlegungen, durch einen ähnlichen Ansatz unter Annahme eines Rotorstillstands ($n$=0) die elektrischen Ersatzschalt-bildgrößen $L_{1\sigma}$, $L'_{2\sigma}$ $L_h$, $R_1$ und $R'_2$ zu bestimmen.

Aus dem Stand der Technik ist zur Bestimmung mechanischer Kenngrößen eines Drehstrommotors, insbesondere zur Fehierdiagnose mechanischer Teile oder zur mechanischen Systemidentifikätion beim Betrieb in einem mechanischen Verband bekannt, ein Pseudo-Rausch-Binär-Signals (PRBS) als elektrische Testanregung einzusetzen. Dabei stellt das mechanische System ein SISO-System (Single-Input Single-Ontput) dar, bei der mit Hilfe einer einzigen mechanischen oder elektrischen Eingangsgröße eine einzige mechanische Ausgangsgröße mittels eines mechanischen Drehgebers gemessen werden kann. Die Eingangsgröße wird mit Hilfe des Pseudo-Rausch-Binär-Signals angeregt, so dass in der Ausgangsgröße ein breitbandiges Verhalten des SISO-Systems bestimmt werden kann. Mit Hilfe signaftheoretischer Methoden der Frequenztransformation und Parameteridentifikation anhand des Frequenzverhaltens können Kenngrößen des mechanischen Systems bei Kenntnis der zugrundeliegenden Systemgleichung abgeleitet werden.

Im Falle einer Bestimmung mechanischer Kenngrößen basierend auf Einspeisung und Messung rein elektrischer Größen handelt es sich allerdings um ein sogenanntes MIMO-System (Multiple-Input Multiple-Output), bei dem mehrere Eingangsgrößen (Strangspannungen) eingespeist und mehrere Ausgangsgrößen (Strangströme) extrahiert werden müssen. Aus diesem Grund können die aus dem Verfahren zur Identifikation mechanischer Größen bekannten Methoden nicht für die elektrische Systemcharakterisierung eines Drehstrommotors angewendet werden. Die Identifikation des mechanischen Systems ist umfassend in der Dissertation von Sebastian Viliwock "Identifikationsmethoden für die automatisierte inbetriebnahme und Zustandsüberwachung elektrischer Antriebe", Universität Siegen, 2007, (Druckschrift [1]) beschirieben. Des Weiteren ist eine diesbezüglich verwendete signaltheoretische Methode für die Parameteridentifikation eines mechanischen Systems in dem Zeitschriftenbeitrag: S. Villwock, J. M. Pacas:„ Applikation of the Welch-Method for the Identification of Two and Three Mass Systems", IEEE Transactions on Industrial Electronics, Vol, 55, No. 1, Januar 2008, S. 457-466 (Druckschrift [2]) beschrieben. Ein gattungsähnliches Verfahren ist im Rahmen eines Konferenzartikels in: P. Szczirpak, J. M. Pacas: "Automatic Identification of a PMSM Drive Equipped with an Output LC-IEEE Industrial Electronics, IECON 2006, 32nd Annual Conference on November 2006, S. 1143-1148 (Druckschrift [3]) vorgestellt.

Aufgabe der vorliegenden Erfindung ist es, ein Verfahren zur Bestimmung von mechanischen Kenngrößen, insbesondere Massenträgheitsmoment J des Rotors für einen ausgehend Drehstrom-Asynchronmotor vorzuschlagen, wobei eine Parameteridentifikation ohne Drehgebersensoren ermöglicht wird, hierbei der Rotor Auslenkungsbewegungen ausführen kann und durch eine einzige Messung die mechanische Kenngrößen ermittelt werden können. Vorteilhafte Fortbildungen der Erfindung sind Gegenstand der Unteransprüche.

Eine weitere Aufgabe der Erfindung besteht darin, eine Vorrichtung zur drehgeberlosen Identifikation vorzuschlagen, bei der die Identifikation der mechanischen Kenngrößen nur über Messung elektrischer Größen vornehmbar ist, so dass keine Sensoren zur Bestimmung des mechanischen Verhaltens der Asynchronmaschine mit angeschlossenem Abtriebsstrang herangezogen werden müssen.

OFFENBARUNG DER ERFINDUNG

In einem ersten Aspekt der Erfindung wird ein Verfahren nach Anspruch 1 vorgeschlagen.

Auslenkungsbewegungen des Rotors bedeuten, dass sich der Winkel $\beta_k$ des Rotors gegenüber dem Stator beliebig während des Messvorgangs ändern kann. Eine Konstantspannungseinprägung in die $\alpha$-Achse des Stators bewirkt einen Konstantstrom $I_{1\alpha}$. Parallel hierzu wird in die $\beta$-Achsenrichtung des Stators ein Testsignal eingespeist. Die Struktur des Testsignals bestimmt, welche Frequenzkomponenten oder -bereiche messbar sind und mit welcher Genauigkeit die mechanischen Kenngrößen identifiziert werden können, wobei Parameter entsprechend der Frequenzabdeckung des Testsignals extrahiert werden können. Bei Einspeisung der Testspannung $U_{1\beta}$ kann ein Meßsignalstrom $I_{1\beta}$ gemessen werden. Die Einspeisung der beiden Strangspannungen zur Messung der beiden Strangströme kann beispielsweise mittels eines 2/3-Phasen-Konverters erfolgen, der obiger Matrixrelation folgend aus den beiden Spannungen $U_{1\alpha}$ und $U_{1\beta}$ die drei Phasenspannungen $U_U$, $U_V$ und $U_W$ erzeugen bzw. aus den drei gemessenen Strömen $I_U$, $I_V$ und $I_W$ die beiden Ströme $I_{1\alpha}$ und $I_{1\beta}$ transformieren kann. Eine Einspeisung des Testsignals $U_{1\beta}$ kann beispielsweise durch eine Steuerung eines Wechselrichters der Motorsteuerungsvorrichtung des Drehstrommotors erfolgen. Alternativ können die Spannungen $U_{1\alpha}$, $U_{1\beta}$ direkt in die Stränge der Asynchronmaschine eingespeist werden. Die Messung des Strangstroms $I_{1\beta}$ kann über die selben Strommessinstrumente erfolgen, die bei einer drehgeberlosen Regelung im Betrieb des Drehstrommotors verwendet werden. Im Zeitbereich können die eingespeisten Testsignalspannungen und die gemessenen Meßsignalströme als digital erfasste zeitliche Abtastwerte aufgezeichnet werden, und auf deren Basis können die mechanischen Kenngrößen bestimmt werden. Dies erfolgt bevorzugt durch eine Frequenzbereichsanalyse, d.h. einer Fouriertransformation der aufgezeichneten Zeitbereichsdaten, und einer Analyse des Frequenzgangs der gemessenen Übertragungsfunktion $G_\beta$. Unter Kenntnis der vorgenannten Admittanzfunktion, die als Übertragungsfunktion im Frequenzbereich dargestellt werden kann, können die Koeffizienten der Übertragungsfunktion mittels einer geeigneten signaltheoretischen Methode ermittelt werden, wobei die koeffizientenbestimmenden Parameter zur Identifikation der mechanischen Kenngrößen, insbesondere Motor-Massenträgheitsmoment J und des angeschlossenen Antriebsstrangs, beispielsweise Getriebe und bewegte Maschinenteile, herangezogen werden können. Der mechanische Antriebsstrang besteht aus dem Rotor der elektrischen Antriebsmaschine und einer gegebenenfalls angekoppelten mechanischen Last einschließlich Getriebe, Wellen und ähnliches.

Im Gegensatz zu einer erfindungsgemäßen unsymmetrischen Testsignaleinspeisung lediglich in die $\beta$-Achse des Stators würde eine identische Einspeisung des Testsignals in $\alpha$- und $\beta$-Koordinatenrichtung ohne Konstantspannungsbeaufschlagung kein Drehmoment in der Maschine erzeugt werden, so dass der Rotor drehmomentfrei und in seiner Lage verbleiben würde. Somit könnten keine Aussagen über mechanische Größen wie Trägheitsmoment J getroffen werden.

Ist am Rotor ein mechanischer Abtriebsstrang einer Maschine angeschlossen, so wird das Trägheitsmoment des gesamten mechanischen Verbundes bestimmbar. Eine Bestimmung des Frequenzgangs des Systems unter Kenntnis der zugrunde liegenden Admittanz-Formel $\underline{G = Y}$ ermöglicht die Bestimmung der Parameter der Übertragungsfunktion. Somit kann durch eine Einspeisung eines insbesondere breitbandigen Testsignals mittels einer einzigen Messung Aussagen über die mechanischen Kenngrößen, die in den Koeffizienten der Übertragungsfunktion enthalten sind, getroffen werden. Hierzu werden signaltheoretische Methoden herangezogen, die die gemessenen Zeitbereichsdaten in Frequenzbereichsdaten transformieren, wobei der Frequenzgang formelmäßig erfasst werden kann, und mittels einer Paramaterextraktion aus dem Frequenzgang die Koeffizienten der zugrundeliegenden Übertragungsfunktion und somit die zugrundeliegenden Parameter und damit die mechanischen Kenngrößen identifiziert werden können.

Grundsätzlich kann statt einer Testspannungsvorgabe und Meßstrombestimmung auch eine Teststromvorgabe mit Meßspannungserfassung erfolgen. Allerdings weisen insbesondere leistungsstarke Motoren ein hochinduktives Verhalten auf, so daß zur Einprägung rechteckförmiger Stromschaltimpulse hohe. Treiberspannungen angelegt werden müßten, worduch eine Teststromeinprägung nur mit hohem Aufwand möglich ist.

Gemäß einer vorteilhaften Weiterbildung kann das Verhältnis von Konstantspannung $U_{1a}$ zur Testsignalspannung $U_{1\beta}$ derart optimiert wählbar ist, um eine Auslenkungsbewegung in einer Höhe zu erreichen, so dass die mechanischen Kenngrößen mit einer vorbestimmbaren Genauigkeit ermittelt werden können. Während der Einspeisung des Testsignals in die $\alpha$- Statorkoordinatenrichtung wird eine Randbedingung erzeugt, so dass eine vereinfachte Bestimmung d.er mechanischen Kenngrößen ermöglicht wird. Allerdings bestimmt die Größe der Konstantstromeinspeisung eine Variation von Koeffizienten der Übertragungsfunktion und eine Ausprägung von Frequenzgangeigenschaften der $\beta$-Admittanzfunktion. Somit ist es wichtig, dass die Amplituden der Konstantspannung und des Testsignals in einem angemessenen Verhältnis stehen. Wäre die Konstantspannung in der $\alpha$-Achse deutlich zu groß oder zu klein, so könnte die Parameteridentifikation nur ungenaue Werte liefern, Das hier beschriebene Verfahren beruht darauf, dass die Maschine sich aus der Flussachse heraus bewegen kann Hierzu kann es vorteilhaft denkbar sein, das Verhältnis von Konstantspannung $U_{1\alpha}$ zur Testsignalspannung $U_{1\beta}$ und/oder die Höhe der Konstantspannung $U_{1\alpha}$ zu variieren- und jeweils Parameteridentifikationen mit geänderten Spannungswerten durchzuführen, wobei die sich ergebenden Parameter als Durchschnitt oder gewichteter Parameter aus den Ergebnissen der einzelnen Parameteridentifikationen ermittelbar sein können. Somit können Fehler in der Bestimmung vermindert werden, so dass ein genaueres Ergebnis erzielt werden kann.

Gemäß einer vorteilhaften Weiterbildung kann zur identifikation der mechanischen Kenngrößen weitere Größten, insbesondere Ersatzschaltbildkenngrößen sowie mechanische Strukturgrößen wie Polpaarzahl $p$ und/oder elektrische Meßgrößen wie $I_{1a}=I_{DC}$ berücksichtigt oder ebenfalls identifiziert werden. Aufgrund der eingespeisten Spannungen und gemessenen Strömen im ortsfesten Koordinatensystem kann die Übertragungsfunktion unter der Annahme $U_{1\alpha}=$ konstant und der Einspelsung eines Testsignals in $U_{1\beta}$ sowie der Kenntnis eines sich einstellenden DG-Stroms $I_{1\alpha}$ und des interessierenden Meßsignalstroms $I_{1\beta}$ folgende Herleitung der Modellfunktion gemacht werden; Die Spannungsgleichungen im statorfesten Bezugssystem lauten:

$$\vec{U}_1^S = R_1 \quad \vec{I}_1^S + \frac{d\vec{\Psi}_1^S}{dt} \quad \text{mit} \quad \vec{\Psi}_1^S = L_1 \quad \vec{I}_1^S + L_h \quad \vec{I}_2^S \quad \text{und} \quad L_1 = L_{1\sigma} + L_h \,,$$

$$\vec{U}_2^S = R_2 \quad \vec{I}_2^S + \frac{d\vec{\Psi}_2^S}{dt} - j \quad \Omega_L \vec{\Psi}_2^S \quad \text{mit} \quad \vec{\Psi}_2^S = L_h \quad \vec{I}_1^S + L_2 \quad \vec{I}_2^S \quad \text{und} \quad L_2 = L_{2\sigma} + L_h \,.$$

Da die Spannung in $\alpha$-Richtung $U_{1\alpha}$ = konstant ist, ergibt sich bei stillstehendem Motor und nach Abklingen der transienten Vorgänge ein konstanter DC-Strom $I_{1\alpha}$ in gleicher Richtung. Mit $I_{1\alpha}$ = konstant = $I_{DC}$ ergeben sich die Flussgleichungen in Komponentendarstellung zu:

$$\Psi_{1\alpha} = L_1 \quad I_{DC} + L_h \quad I_{2\alpha} \,, \quad \Psi_{1\beta} = L_1 \quad I_{1\beta} + L_h \quad I_{2\beta}$$

Es zeigt sich, dass bei Anregung der Maschine mit einem Testsignal in $\beta$-Richtung der Gleichstrom in $\alpha$-Richtung konstant bleibt. Es folgt somit für den Realteil der Ständerspannungsgleichung der Zusammenhang:

$$\underbrace{U_{1\alpha}}_{=konst} = \underbrace{R_1 \quad I_{1\alpha}}_{konst} + L_1 \quad \underbrace{\frac{dI_{DC}}{dt}}_{=0} + L_h \quad \underbrace{\frac{dI_{2\alpha}}{dt}}_{\rightarrow =0} \,.$$

Somit folgt für den Realteil des Raumzeigers der Läuferflussverkettung:

$$\Psi_{2\alpha} = L_1 \quad I_{DC}$$

$$U_{2\alpha} = 0 = \underbrace{R_2 \quad I_{2\alpha}}_{=0} + L_h \cdot \underbrace{\frac{dI_{DC}}{dt}}_{=0} + L_2 \cdot \underbrace{\frac{dI_{2\alpha}}{dt}}_{=0} + \Omega_L \cdot \Psi_{2\beta}$$

$$\rightarrow U_{2\alpha} = \Omega_L \cdot \Psi_{2\beta} = 0,$$

da Kurzschlussläufer und somit $\Psi_{2\beta} = 0$

Der Raumzeiger der Läuferflussverkettung weist demzufolge lediglich einen Realteil auf. Die Spannungsgleichungen in β-Richtung lauten somit:

$$U_{1\beta} = R_1 \quad I_{1\beta} + L_1 \cdot \frac{dI_{1\beta}}{dt} + L_h \cdot \frac{dI_{2\beta}}{dt}$$

$$U_{2\beta} = R_2 \quad I_{2\beta} + L_h \cdot \frac{dI_{1\beta}}{dt} + L_2 \cdot \frac{dI_{2\beta}}{dt} - \Omega_L \cdot \underbrace{\Psi_{2\alpha}}_{=L_h \, I_{DC}}$$

Übergang in den Bildbereich der Laplace-Transformation:

$$U_{1\beta} = I_{1\beta} \left( R_1 + s \quad L_1 \right) + L_h \cdot s \cdot I_{2\beta}$$

$$\rightarrow I_{2\beta} = \frac{U_{1\beta} - I_{1\beta} \left( R_1 + s \quad L_1 \right)}{L_h \cdot s} \qquad\qquad\qquad (\text{Gl 1})$$

dabei gilt $U_{2\beta} = I_{2\beta} (R_2 + s L_2) + L_h \cdot s \cdot I_{1\beta} - \Omega_L \cdot L_h \cdot I_{DC} = 0$, da der Asynchronmotor einen Kurzschlussläufer als Rotor aufweist, so dass gefolgert werden kann:

$$\rightarrow 0 = \frac{U_{1\beta}}{L_h \cdot s} \left( R_2 + s \quad L_2 \right) + I_{1\beta} \left( L_h \cdot s - \frac{\left( R_1 + s \quad L_1 \right) \left( R_2 + s \quad L_2 \right)}{L_h \cdot s} \right) - \Omega_L \cdot L_h \cdot I_{DC} \qquad (\text{Gl 2})$$

Für das Drehmoment der Maschine gilt:

$$M = \frac{3}{2} \cdot p \cdot \mathrm{Im} \left\{ \bar{\Psi}_1^{S*} \quad \bar{I}_1^{S} \right\} = \frac{3}{2} \cdot p \cdot \mathrm{Im} \left\{ \left( \Psi_{1\alpha} - j \quad \Psi_{1\beta} \right) \cdot \left( I_{1\alpha} + j \quad I_{1\beta} \right) \right\} = \frac{3}{2} \cdot p \cdot \left( \Psi_{1\alpha} \quad I_{1\beta} - \Psi_{1\beta} \quad I_{1\alpha} \right)$$

Mit $\Psi_{1\alpha} = L_h \, I_{DC}$ und $\Psi_{1\beta} = L_1 \, I_{1\beta} + L_h \, I_{2\beta}$ erhält man

$$M = \frac{3}{2} \cdot p \cdot I_{DC} \cdot \left( L_h \, I_{1\beta} - L_1 \, I_{1\beta} - L_h \, I_{2\beta} \right)$$

Mit (Gl 1) eingesetzt in obige Relation folgt:

$$M = \frac{3}{2} \cdot p \cdot I_{DC} \cdot \left( -\frac{U_{1\beta}}{s} + I_{1\beta} \cdot \frac{R_1 + s \quad L_1}{s} + L_h \quad I_{1\beta} - L_1 \quad I_{1\beta} \right) = \frac{3}{2} \cdot p \cdot I_{DC} \cdot \left( -\frac{U_{1\beta}}{s} + I_{1\beta} \cdot \frac{R_1 + s \quad L_h}{s} \right)$$

Der Zusammenhang zwischen mechanischer und elektrischer Kreisfrequenz lautet:

$$\Omega_L = p \cdot \Omega_m = p \cdot \frac{1}{J} \int M \; dt$$

Im Bildbereich erhält man mit obigem Zusammenhang für das Drehmoment

$$\Omega_L = \frac{p}{J} \cdot \frac{1}{s} \cdot \frac{3}{2} \cdot p \cdot \frac{I_{DC}}{s} \cdot \left( -U_{1\beta} + I_{1\beta} \left( R_1 + s \quad L_h \right) \right) = \frac{3}{2} \frac{p^2}{J} \frac{I_{DC}}{s^2} \cdot \left( -U_{1\beta} + I_{1\beta} \left( R_1 + s \quad L_h \right) \right) ,$$

da sich im Laplacebereich eine Zeitintegration als Division durch s ergibt.
Einsetzen dieses Zusammenhangs für $\Omega_L$ in (Gl 2) ergibt

$$0 = \frac{U_{1\beta}}{L_h \cdot s} \left( R_2 + s \quad L_2 \right) + I_{1\beta} \left( L_h s - \frac{\left( R_1 + s \quad L_1 \right) \left( R_2 + s \quad L_2 \right)}{L_h \cdot s} \right) - \frac{3}{2} \frac{p^2}{J} \frac{I_{DC}^2}{s^2} \left( -U_{1\beta} + I_{1\beta} \left( R_1 + s \quad L_h \right) \right) \cdot L_h$$

Nach einigen Umformungen erhält man die gewünschte Übertragungsfunktion:

$$G_\beta = \underline{Y} = \frac{I_{1\beta}}{U_{1\beta}} = \frac{-2 \cdot \left( R_2 + s \quad L_2 \right) \cdot s \cdot J - I_{DC}^2 \cdot p^2 \cdot L_h^2 \cdot 3}{2 \cdot J \cdot s \left( L_h^2 \cdot s^2 - R_1 \quad R_2 - s \left( L_1 \quad R_2 + L_2 \quad R_1 \right) - s^2 \cdot L_1 \quad L_2 \right) - I_{DC}^2 \cdot p^2 \cdot L_h^2 \cdot \left( R_1 + s \quad L_h \right) \cdot 3}$$

, die sich mittels $k := \dfrac{3 \cdot I_{DC}^2 \cdot p^2 \cdot L_h^2}{2 \cdot J}$ dergestalt vereinfachen lässt:

$$G_\beta = \underline{Y} = \frac{I_{1\beta}}{U_{1\beta}} = \frac{s^2 \cdot L_2 + s \cdot R_2 + k}{-s^3 \cdot \left( L_h^2 - L_1 \quad L_2 \right) + s^2 \cdot \left( L_1 \quad R_2 + L_2 \quad R_1 \right) + s \cdot \left( R_1 \quad R_2 + k \quad L_h \right) + k \quad R_1} \quad \text{(Gl 3)}$$

Diese Gleichung lässt sich parametriert schreiben als:

$$G_\beta = \underline{Y} = \frac{I_{1\beta}}{U_{1\beta}} = \frac{s^2 \cdot a_2 + s \cdot a_1 + a_0}{s^3 \cdot b_3 + s^2 \cdot b_2 + s \cdot b_1 + b_0}$$

mit

$$a_2 = L_2, \; a_1 = R_2, \; a_0 = k, \; b_3 = -\left( L_h^2 - L_1 L_2 \right), \; b_2 = \left( L_1 R_2 + L_2 R_1 \right), \; b_1 = \left( R_1 R_2 + k \quad L_h \right), \; b_0 = k R_1 .$$

Zur Bestimmung der Koeffizienten $a_0$, $a_1$, $a_2$, $b_0$, $b_1$, $b_2$ und $b_3$ wird das Wissen über die elektrischen Größen der Ersatzschaltbildparameter $L_{1\sigma}$, $L'_{2\sigma}$, $L_h$, $R_1$ und $R'_2$ sowie über die Polpaarzahl $p$, die Höhe des DC-Stroms $I_{1\alpha}$

benötigt. Die Polpaarzahl als Strukturgröße des Motors ist im vorhinein bekannt, die Höhe des DC-Stroms lässt sich messtechnisch bestimmen. Die Größe der Ersatzschaltbildparameter kann beispielsweise aus Kurzschluss-, Gleichstrom- und Leerlaufversuchen ermittelt werden, oder durch ein auf einer vergleichbaren Erfindungsidee beruhenden Strom/Spannungsmessungsmessverfahren, das Gegenstand einer parallelen Patentanmeldung ist, ermittelt werden. Unter Kenntnis dieser Größen kann der Parameter $k$ und hieraus das Massenträgheitsmoment J des Rotors bzw. des Antriebsstrangs identifiziert werden. Daneben können die Kenngrößen oder Ersatzschaltbildparameter, die in den Koeffizienten der Übertragungsfunktion charakterisiert sind, ebenfalls im Rahmen der Parameteridentifikation bestimmt werden. So ist denkbar, aus den bestimmten Koeffizienten der Übertragungsfunktion alle in die Übertragungsfunktion einfließenden Parameter, zumindest jedenfalls die elektrischen Ersatzschaltbildparameter zu identifizieren.

Gemäß einer vorteilhaften Weiterbildung kann das Testsignal ein Pseudo-Rausch-Binär-Signal sein. Das Testsignal sollte eine hohe Bandbreite aufweisen, um eine möglichst hohe Frequenzauflösung des elektrischen Motorverhaltens zu ermöglichen. Weißes Rauschen besitzt ein gleichverteiltes breitbandiges Frequenzspektrum. Ein Pseudo-Rausch-Binär-Signal (PRBS) ist ein binäres Signal, welches das Spektrum von weißem Rauschen approximiert. Es kann typischerweise die Werte +1 und -1 annehmen und wird alternativ zum weißen Rauschen verwendet. Vorteilhaft ist insbesondere die Reproduzierbarkeit des Signals, wobei häufig in der Regelungstechnik ein PRB-Signal zur Analyse eine Impulsantwort mittels einer Maximum-Length-Sequence verwendet wird. Ein PRB-Testsignal lässt sich sehr einfach durch linear rückgekoppelte Schieberegister erzeugen und kann beispielsweise durch einen DSP (Digital Signal Processor), FPGA (Field Programmable Gate Array) oder Mikrocontroller eines Motorreglers zur Ansteuerung des Wechselrichters erzeugt werden. Somit kann jede Motoransteuerelektronik solch ein PRB-Signal ohne größere Modifikation erzeugen und als Motorspannung in den Motor einspeisen.

Grundsätzlich kann eine Frequenzbereichstransformation von abgetasteten Zeitbereichsdaten zur Identifikation der Ersatzschaltbildparameter im Frequenzbereich beliebig erfolgen. Gemäß einer vorteilhaften Weiterbildung der Erfindung kann die Identifikation der Ersatzschaltbildparameter eine Fouriertransformation nach einem Periodogramm-Verfahren, bevorzugt ein Bartlett-Verfahren, insbesondere einem Welch-Verfahren umfassen. Im Rahmen eines Periodogramm-Verfahrens wird eine spektrale Leistungsdichte durch eine Fourier-Transformation einzelner Datenblöcke erreicht. Die Qualität der Spektralschätzung kann verbessert werden, indem eine Anzahl voneinander unabhängiger Periodogramme gemittelt wird. Dieses Verfahren ist in der Literatur unter dem Namen Bartlett-Methode bekannt, bei dem das gemessene Signal in Abschnitte aufgeteilt wird. Die Welch-Methode stellt eine Erweiterung der von Bartlett vorgeschlagenen Vorgehensweise dar. Zur Reduzierung des Leck-Effekts (engl. *Leakage-effect*) kommen hier bestimmte Fensterfunktionen zum Einsatz. Der störende Leck-Effekt tritt dann auf, wenn der Signalabschnitt nicht periodisch, ein ganzzahliges Vielfaches der Periode oder dieser Signalabschnitt an den Rändern von null verschieden ist. Die Anwendung eines Welch-Verfahrens bei der Identifikation eines Zwei- oder Dreimassensystems ist bereits aus der oben genannten Druckschrift [2] bekannt. Das Welch-Verfahren spaltet M-Abtastwerte in K-Teilfolgen auf, die mit einer Fensterfunktion gewichtet werden, und auf die eine Fouriertransformation angewendet wird. Die in der Druckschrift [1] beschriebene Welch-Methode ermöglicht die Transformation einer beliebigen Zahl von Abtastwerten mit einer möglichst hohen Genauigkeit in den Frequenzbereich. Hierbei werden die Zeitbereichsdaten gefenstert, die gefensterten Daten in Teilfolgen aufgeteilt und fouriertransformiert, und hieraus Periodigramme ermittelt, die zur Bestimmung der Übertragungsfunktion, in diesem Fall der Admittanz-Funktion, im Frequenzbereich herangezogen werden können.

Alternativ hierzu kann allerdings auch eine Korrelogramm-Methode, die in der Literatur auch unter dem Namen Blackman-Tukey-Schätzung bekannt ist, eingesetzt werden Dabei erfolgt die Spektralschätzung auf Grundlage einer Autokorrelationsfunktion (AKF) und einer Kreuzkorrelationsfunktion (KKF), die aus dem Testsignal (Anregungssignal) und dem Meßsignal (Antwortsignal) berechnet wird. Bei diesem Ansatz erhält man die spektrale Leistungsdichte durch Fourier-Transformation der zuvor geschätzten AKF und KKF. Die Welch-Methode liefert allerdings robustere Ergebnisse.

Ausgehend von der im Frequenzbereich vorliegenden Darstellung einer bekannten Übertragungsfunktion, beispielsweise des Admittanzverlaufs, können mechanische Kenngrößen des Drehstrommotors extrahiert werden. Hierzu gibt es bereits einige numerische Ansätze. Besonders vorteilhaft kann ein Levenberg-Marquardt-Algorithmus in einer Weiterbildung der Erfindung verwendet werden, um die Kenngrößen mittels einer Übertragungsfunktionsparameterbestimmung zu identifizieren. Alternativ kann beispielsweise ein Verfahren nach Nelder und Mead verwendet werden, wobei allerdings der Levenberg-Marquardt-Algorithmus, insbesondere bei stark verrauschten Datensätzen robustere Ergebnisse liefert. Er gehört zur Gruppe von Gradienten-Verfahren, wobei durch iteratives Minimieren einer Fehlerfunktion bessere Parametervektoren berechnet werden können, die den Koeffizienten der Übertragungsfunktion entsprechen. Das Levenberg-Marquardt-Verfahren gilt momentan als Standardverfahren für nicht lineare Optimierungen. Es ist eine Mischung aus Gradienten-Verfahren und Inversion einer Hesse-Matrix und wird in der Literatur auch als Methode des steilsten Abstiegs bezeichnet. Die Inversion der Hesse-Matrix wird auch als Gauss-Newton-Verfahren bezeichnet. In Druckschrift [1] ist eine detaillierte Darstellung der Anwendung des Levenberg-Marquardt-Algorithmus vorgestellt, wobei ausgehend von einer Übertragungsfunktion:

$$G = \frac{s^2 \cdot a_2 + s \cdot a_1 + a_0}{s^3 \cdot b_3 + s^2 \cdot b_2 + s \cdot b_1 + b_0}$$

und unter Vorlage des Frequenzgangs des Systems die unbekannten Koeffizienten $a_0$, $a_1$, $a_2$, $b_0$, $b_1$, $b_2$ und $b_3$ bestimmt werden können. Im Vergleich mit der oben genannten Admittanzdarstellung entsprichen diese Koeffizienten den

Parametern: $a_2 = L_2$, $a_1 = R_2$, $a_0 = k$, $b_3 = -\left( L_h^2 - L_1 L_2 \right)$, $b_2 = \left( L_1 R_2 + L_2 R_1 \right)$,

$b_1 = (R_1 R_2 + k L_h)$, $b_0 = kR_1$. Durch die Ermittlung der unbekannten Koeffizienten $a_0$, $a_1$, $a_2$, $b_0$, $b_1$, $b_2$ und $b_3$ lässt sich

somit zumindest die Massenträgheitsmoment $J$ durch $J = \dfrac{3 \cdot I_{DC}^2 \cdot p^2 \cdot L_h^2}{2 \cdot k}$ identifizieren, allerdings können auch die weiteren Größen, insbesondere elektrischen Ersatzschaltbildparameter hierdurch identifizierbar sein.

Gemäß einer vorteilhaften Weiterbildung der Erfindung können die identifizierten mechanischen Kenngrößen bei einer Einstellung und/oder Optimierung von Wechselrichter-Steuerparametern und/oder zur Motorüberwachung verwendet werden. Bei der Regelung moderner Asynchronmaschinen werden Motorsteuerungsvorrichtungen eingesetzt, die bei schnellen Drehzahlübergängen oder bei Bereitstellung dynamisch regelbarer Abtriebsenergie aufgrund der Kenntnis des dynamischen mechanischen Verhaltens entsprechend den Wechselrichter steuern können bzw. die Strangantriebsspannungen derart vorgeben können, dass die Maschine optimal ohne Überschwingen die gewünschten Arbeitsaufgaben erfüllen kann. In diesem Zusammenhang werden die Begriffe Steuerung und Regelung synonym verwendet. Die Kenntnis der mechanischen Dynamikgrößen, insbesondere Massenträgheitsmoment der Antriebsstrecke kann der Parametrierung des Stromreglers dienen, dessen Anforderung an eine hohe Dynamik als innerster Regler am höchsten ist. Insbesondere anspruchsvolle Regelungsverfahren, die über die von konventionellen PI-Reglern hinausgehen, verlangen eine präzise Kenntnis des dynamischen Maschinenverhaltens, insbesondere des Massenträgheitsmoments J. Hierbei sind insbesondere Zustandsraumregler, Dead-Beat-Regler oder Modellfolgeregler zu nennen. Da in jüngster Zeit insbesondere sensorlose Motorsteuerungen eingesetzt werden, können mittels des vorgeschlagenen drehgeberlosen Verfahrens das Dynamikverhalten in einer komplexen Maschinenumgebung ermittelt werden, und der Motorregler vor Ort eingestellt werden. Die Massenträgheit J stellt eine entscheidende Kenngröße des dynamischen Antriebsverhaltens dar, so dass insbesondere bei der Regelung komplexer transienter Übergangsvorgänge der Maschine eine genaue Ansteuerung des Wechselrichters ermöglicht wird. Hierbei wird eine überschwingfreie Reglereinstellung und eine optimiert schnelle Dynamikregelung des Motors ermöglicht. Denkbar ist insbesondere die Anwendung einer solchen optimierten Motorregelung im Bereich von Druckmaschinen, Kunststoffoberflächen-Herstell- und Bearbeitungsmaschinen oder von Walz- und Verpackungsmaschinen, bei denen dynamikoptimierte Motorsteuerungsverfahren eingesetzt werden müssen. Insbesondere bei Vierfarbdruckmaschinen können kleinste Abweichungen im Farbdruck bei Motorsteuerungsungenauigkeiten erkennbar werden. Bei der Herstellung extrem glatter und dünner Kunststofoberflä-chen kann eine gleichmäßige Dicke der Kunststoffschicht nur bei optimaler Dynamikregelung erreicht werden, wobei keine optischen Verunreinigungen des Kunststoffmaterials auftreten können. Während der Analyse der mechanischen Kenngrößen bewegt sich der Rotor nur geringfügig ohne Gefahr einer mechanischen Überlastung, wobei das Massenträgheitsmoment im eingebauten Zustand des Motors ohne merklichen Einfluss des Abtriebsstrangs elektrisch identifiziert werden kann. Eine Reglerparametrierung dient der Optimierung der Steuerparameter des Wechselrichters, wobei eine Abweichung der Kenngrößen von beispielsweise vorhergegangenen Messungen zur Fehlerüberwachung des Motors oder zur Verschleißkontrolle berücksichtigt werden kann. Insbesondere kann der Einsatz des Verfahrens im Rahmen eines "Condition Monitoring" des Motors vorteilhaft sein, so dass von Zeit zu Zeit das Verfahren die Kenngrößen neu ermitteln, adaptiv den Motorregler anpassen und bei auffälligen Abweichungen gegenüber zuvor identifizierten oder voreinstellbaren Parameterwerten eine Fehlersignalisierung ausgeben kann, so dass Motor oder Ansteuerelektronik überprüft werden können.

Gemäß eines nebengeordneten Aspekts der Erfindung wird eine Identifikationseinrichtung nach Anspruch 8 vorgeschlagen.

Somit betrifft diese Erfindung eine Identifikationseinrichtung, die dazu ausgelegt ist, ein vorgenanntes Verfahren auszuführen und hierzu die Möglichkeit eröffnet, mittels einer Wechselrichter-Interfaceeinheit mit einer Wechselrichter-Steuereinrichtung, insbesondere mit den Halbleiterschaltbauteilen des Wechselrichters zu kommunizieren, um diese zu schalten bzw. deren Betriebszustand abzufragen. Durch Vorgabe einer $U\alpha$ Gleichspannung kann der Wechselrichter einen Konstantstrom $I_{Dc}$ in die $\alpha$-Achse des Motors einprägen. Parallel hierzu wird in der $\beta$-Achse eine Testsignalspan-nung vorgegeben, aufgrund derer ein Meßsignalstorm $I_\beta$ gemessen werden kann, wodurch der Rotor in eine schaukelnde Drehbewegung versetzt werden kann. Die Identifikationseinrichtung umfasst eine Testsignalerzeugungseinrichtung, die die DC-Spannung der α-Achse und das β-Testsignal erzeugen kann, wobei das Testsignal, insbesondere ein PRB-Rauschsignal, mittels einer *U/V/W*-Transformationseinheit in ein *U/V/W*-Steuertestsignal umgewandelt werden kann, das der Wechselrichter-Steuereinrichtung zuführbar ist. Das Steuertestsignal erzeugt in dem Motor ein entsprechendes Testsignal in den drei Motorsträngen. Des Weiteren umfasst die Identifikationseinrichtung eine α/β-Transformationseinheit, die die gemessenen $I_U$, $I_V$ und $I_W$ -Meßsignalströme in α/β-Meßsignalströme $I_a$ und $I_\beta$ umwandeln kann und eine Parameteridentifikationseinheit, die ausgehend von der im Zeitbereich vorliegenden Testsignalspannungen $U_\alpha$, $U_\beta$ und gemessenen Meßsignalströme $I_\alpha$ $I_\beta$, eine Parameteridentifikation nach vorgenannten Verfahren durchführen kann. Eine derartige Identifikationseinrichtung kann beispielsweise mehrteilig aufgebaut sein, wobei zur Erzeugung des Testsignals der Motorkontroller einer Motorsteuervorrichtung verwendet werden kann. Die gemessenen Ströme können ebenfalls von der Motorsteuerungsvorrichtung aufgezeichnet werden. Ein externer Rechner kann diese gemessenen und eingespeisten Spannungen und Ströme auslesen, in den Frequenzbereich transformieren und eine Parameteridentifikation durchführen.

Gemäß einer vorteilhaften Weiterbildung der Identifikationseinrichtung kann die Parameteridentifikationseinheit ein Fouriertransformationsmittel, insbesondere ein FFT/DFT-Mittel zur Fouriertransformation diskontinuierlicher α/β-Abtast-Signalwerte nach dem Welch-Verfahren und ein Parameterbestimmungsmittel, insbesondere ein Levenberg-Marquardt-Übertragungsfunktions-Parameterbestimmungsmittel umfassen. Demgemäß umfasst die Parameteridentifikationseinheit ein Fouriertransformationsmittel zur Überführung der eingespeisten und gemessenen Spannungs- und Strom-Zeitabtastwerte $U_{1\beta}$, $I_{1\beta}$ und ein Parameterbestimmungsmittel, das ausgehend von im Frequenzbereich vorliegenden Übertragungsfunktionen $G = I_{1\beta}/U_{1\beta}$ eine Bestimmung der Übertragungsfunktions-Koeffizienten $a_0$, $a_1$, $a_2$, $b_0$, $b_1$, $b_2$ und $b_3$ vornehmen kann. Die hierzu notwendigen Rechenverfahren können beispielsweise innerhalb eines DSPs, eines Mikrocontrollers eines FPGAs, eines PCs oder eines Kleinrechners durchgeführt werden, wobei eine logische und bauliche Trennung zwischen Testsignalerzeugung, Abtastwertspeicherung, Fouriertransformation und Parameterbestimmung möglich ist. Die Signalverarbeitung und das anschließende numerische Verfahren kann vorteilhaft als Softwareimplementierung zumindest teilweise auf einem Motorregler bzw. Motorsteuerungsvorrichtung vorgesehen sein.

So ist denkbar, das Fouriertransformationsmittel als FPGA aufzubauen, um eine schnelle Fouriertransformation mit Hilfe eines statischen Schaltkreises zu realisieren, und das Parameteridentifikationsmittel als variable Rechensoftware auf einem Hochleistungs-DSP eines Motorsteuerreglers zu implementieren. Eine Testsignalerzeugung und Abtastwertspeicherung kann innerhalb einer Wechselrichter-Motorsteuerungsvorrichtung durchgeführt werden. Fouriertransformation und Parameteridentifikation kann ebenfalls durch eine Motorsteuerungsvorrichtung oder durch eine externe Identifikationseinrichtung, die ein Interface zur Kommunikation mit der Motorsteuerungsvorrichtung aufweist, erfolgen. Somit kann die Motorsteuerungsvorrichtung mit geringer Rechenleistung ausgerüstet sein, und anspruchsvolle signaltheoretische Aufgaben in einer externen Identifikationseinrichtung, die an die Motorsteuerungsvorrichtung anschließbar ist, abgearbeitet werden, wodurch Hardwareaufwand eingespart werden kann.

Gemäß einer vorteilhaften Weiterbildung kann die Einrichtung des Weiteren eine Überwachungs- und Optimierungseinheit umfassen, die eingerichtet ist, auf Basis der mechanischen Kenngrößen Steuerparameter einer Wechselrichter-Steuereinrichtung zu bestimmen, zu optimieren und/oder zu überwachen. Die Überwachungs- und Optimierungseinheit empfangt die bestimmten Kenngrößen der Parameteridentifikationseinheit und kann auf Basis der bestimmten mechanischen Kenngrößen Steuerungsparameter der Motorsteuervorrichtung optimieren, insbesondere hinsichtlich eines dynamischen Reglerverhaltens und/oder Filtereigenschaften, um die Auswirkungen des induktiven Verhaltens des Asynchronmotors auf das Netz zu verringern. Des. Weiteren kann ein effizienter Betrieb der Motorsteuerung optimiert und Motorveränderungen überwacht bzw. beim Motorausfall oder Fehlverhalten ein Fehlersignal ausgegeben werden. Das zu berücksichtigende dynamische Maschinenverhalten kann im Rahmen eines "Condition-Monitorings" durch die Überwachungs- und Optimierungseinheit routinemäßig nach einem bestimmten Zeitintervall oder beispielsweise bei Auswechseln des Motors oder Motorteilen erneut identifiziert werden.

In einem nebengeordneten Aspekt schlägt die Erfindung eine Motorsteuerungsvorrichtung zur drehgeberlosen Steuerung bzw. Regelung eines Drehstrom-Asynchronmotors vor, die eine zuvor beschriebene Identifikationseinrichtung zur drehgeberlosen Identifikation mechanischer Kenngrößen umfasst, wobei die mechanischen Kenngrößen zur Bestimmung, Optimierung und Überwachung des Motors und/oder der Motorsteuerung verwendbar sind. Somit schlägt dieser Aspekt eine Motorsteuerungsvorrichtung vor, die in üblicher Weise eine sensorbasierte oder drehgeberlose Steuerung des Drehzahlverhaltens des Asynchronmotors vornehmen kann, die eine Identifikationssinrichtung umfasst oder in Verbindung mit einer solchen Identifikationseinrichtung steht, und die die identifizierten Kenngrößen zur Optimierung des Regelverhaltens, zur Bestimmung elektrischer Größen und des Dynamikverhaltens für die Ansteuerung des Motors und für die Überwachung eines fehlerfreien Verhaltens des Asynchronmotors und/oder der Motorsteuerung verwendet. So können die ermittelten Kenngrößen zur optimalen Einstellung von Steuerungskennlinien dienen, so dass ein dynamisches Regelverhalten überschwingfrei ermöglicht werden kann. Somit können die identifizierten Parameter zur Optimierung des Stromverbrauchs und der Energieeffizienz des Asynchronmotors herangezogen werden und beispielsweise für eine Filterparametrierung zur Einstellung elektronischer Filter eingesetzt werden oder sie können zur Überwachung des fehlerfreien Verhaltens der Motorsteuerungsvorrichtung und/oder des Asynchronmotors herangezogen werden. Im Falle eines vorbestimmbaren Abweichens der identifizierten Kenngrößen gegenüber zuvor bestimmten oder vorgegebenen Kenngrößen kann ein Fehlerfall angenommen werden, beziehungsweise eine Neubestimmung der Kenngrößen durchgeführt werden. Im Falle einer Reparatur oder einer Auswechslung des Motors kann die Motorsteuerungsvorrichtung adaptiv die Kenngrößen des neuen Motors identifizieren und sich optimiert auf den neuen Motor einstellen. Eine solche Selbstkalibrierung der Motorsteuerungsvorrichtung kann werksseitig erfolgten, oder beim Einbau oder Maschine beim Kunden, beziehungsweise im laufenden Betrieb im Rahmen eines "Condition Monitorings".

In einer vorteilhaften Weiterbildung wird vorgeschlagen, dass die Motorsteuerungsvorrichtung derart eingerichtet ist, dass zumindest bei der erstmaligen Inbetriebnahme, bevorzugt mehrmals im Laufe des Betriebsiebens, eine automatisierte Identifikation der mechanischen Größen vornehmbar ist, wobei bei einer vorstellbaren Abweichung der identifizierten mechanischen Kenngrößen von vorherig bestimmten gespeicherten und/oder modellbezogenen Kenngrößen, eine Fehlersignalisierung auslösbar ist. Somit schlägt dieser Aspekt vor, dass zumindest bei einer erstmaligen Inbetriebnahme, beziehungsweise einem Testlauf werksseitig, bevorzugt jedoch im Rahmen eines "Condition Monitorings", oder bei Reparatur oder Austausch von Teilen des Motors eine Kenngrößenidentifikation vorgenommen wird, wobei die Motorsteuerungsvorrichtung zur Optimierung, Einstellung und Überwachung des Motors diese mechanischen Kenngrößen befücksichfigen kann. Somit kann eine "universelle" Motorsteuerungsvorrichtung geschaffen werden, die sich adaptiv an eine ganze Reihe unterechiedlicher Asynchronmotoren anpassen kann, wobei im Motorstillstand eine Identifikation der elektrischen Größen vornehmbar ist. Alterungsbedingte Veränderungen des Motors können durch eine adaptive Korrektur der Reglerparameter berücksichtigt werden und Fehlfunktionen des Motors oder der Motorsteuerungsüberwachung können erkannt werden.

Schließlich wird in einem nebengeordneten Aspekt der Erfindung eine Verwerdung des vorgenannten Verfahrens zur Bestimmung, Optimierung und Überwachung von Motorregelparametern für die Steuerung bzw. Regelung elektrischer Antriebe, insbesondere zur Einstellung von Regefungsparametem einer Motorsteuerungsvorrichtung vorgeschlagen. In diesem Aspekt wird vorgeschlagen, dass die ermittelten mechanischen Kenngrößen zur Regleroptimierung, Parametrierung und Überwachung eingesetzt werden. Eine Ermittlung der mechanischen Kenngrößen kann beispielsweise für eine Baureihe von Asynchronmotoren einmalig an einem Mustermotor vorgenommen werden, und entsprechende Regelparameter für die hierfür eingesetzten Motorsteuerungsvorrichtungen optimiert und angepasst werden. Dies kann werksseitig erfolgen. Ist in einer Motorsteuerungsvorrichtung eine Identifikationseinrichtung vorgesehen oder extern anschließbar, so kann diese im eingebauten Zustand des Motors bei Erstinbetriebnahme, bei Reparaturmaßnahmen oder routinemäßiger oder laufender Zustandsüberwachung ("Condition Monitoring") eine Neuidentifikation der Parameter vornehmen. Hierzu können Teile des Verfahrens, wie die Frequenzbereichstransformation und die Parameterbestimmung, auf einem externen Rechner ausgeführt werden, und andere Teile, wie beispielsweise die Einspeisung des Testsignals und die Konvertierung vom Dreiphasensystem in das Zweikoordinatensystem, innerhalb der Motorsteuerungsvorrichtung vorgenommen werden. Entscheidend ist jedoch, dass die identifizierten mechanischen Kenngrößen zur optimalen Reglerparametrierung, Filtereinstellung, elektrischer Bauteildimensionierung verwendbar sind.

Zeichnungen

Weitere Vorteile ergeben sich aus der folgenden Zeichnungsbeschreibung. In der Zeichnung sind Ausführungsbeispiele der vorliegenden Erfindung dargestellt. Die Zeichnung, die Beschreibung und die Ansprüche enthalten zahlreiche Merkmale in Kombination. Der Fachmann wird die Merkmale zweckmäßigerweise auch einzeln betrachten und zu sinnvollen weiteren Kombinationen zusammenfassen.

Es zeigen beispielhaft:

Fig. 1    ein Ersatzschaltbild einer Statorspule eines Asynchronmotors in Sternschaltung;

Fig. 2    Darstellung des Zusammenhangs zwischen Zweikomponenten- und Dreiphasenkoordinatensystems;

Fig. 3    schematisch ein Aufbau eines Asynchronmotors mit Kurzschlussläufer;

Fig. 4    ein T-Ersatzschaltbild eines Asynchronmotors;

Fig. 5    ein erstes Ausführungsbeispiel einer Motersteuerungsvorrichtung der Erfindung;

Fig. 6    ein Ausführungsbeispiel einer Motorsteuerungsvorrichtung gemäß der Erfindung;

Fig. 7    einen Ablaufplan eines Ausführungsbeispiels eines erfindungsgemäßen Verfahrens;

**Fig. 8**    schematisch ein Ausführungsbeispiel einer Testsignaleinspeisung in ein mathematisches Modell eines Asynchronmotors;

**Fig.9**    einen Betrag-Phasenverlauf einer Admittanz aus gemessenen Zeitbereichsdaten bei Anwendung eines erfindungsgemäßen Verfahrens;

AUSFÜHRUNGSFORMEN DER ERFINDUNG

In den Figuren sind gleiche oder gleichartige Komponenten mit gleichen Bezugsziffern bezeichnet

Zur Erläuterung der Erfindung zeigt Fig. 1 ein Ersatzschaltbild der Statorspule 01 eines Drehstrommotors. Jeder Spulenstrang $U$, $V$ und $W$ umfasst einen Spulenwiderstand $R_s$ 03 und eine Spuleninduktivität $L_s$ 05. Die drei Spulenstränge 07 sind an ihrem ersten Ende miteinander verbunden und an ihrem zweiten Ende an die drei Phasen $U$, $V$, $W$ des Ausgangs eines Wechselrichters angeschlossen. Die Statorspule 01 interagiert mit der drehbar gelagerten Rotorspule 11, in der bei Einprägung eines sich drehenden Magnetfelds der Statorspule 01 eine Spannung induziert wird, die ein entgegen gerichtetes Rotormagnetfeld erzeugt, durch das sich der Motor in Drehung versetzt. Die Drehzahl des Rotors 11 eilt der Magnetdrehgeschwindigkeit der Statorspule 01 hinterher, wodurch weiterhin Spannung in den Rotor 11 induziert wird. Der Grad des Nacheilens wird als Schlupf s bezeichnet. Das System aus Rotorspule 11 und Statorspule 01 kann statt in einem Drehphasensystem $U/V/WI$ in einem Stator-Zweikoordinatensystem $\alpha/\beta$ oder Rotor-Zweikoordinatensystem d/q betrachtet werden, woraus das in Fig. 4 dargestellte T-Ersatzschaltbild des Motors abgeleitet werden kann.

Hierzu zeigt zunächst Fig. 2 die räumliche Zuordnung des Dreiphasensystems $UN/W$ mit den drei Koordinatenrichtungen 1 (0°), $e^{j2\pi/3}$ (120°) und $e^{j4\pi/3}$ (240°) gegenüber dem $\alpha$ /$\beta$ Koordinatensystem der komplexen Ebene mit Realteil und Imaginärteil. Unter Annahme eines Gesamtstroms $I$ kann dieser in Bezug auf das Dreiphasensystem in drei Teilströme $I_U$, $I_V$ und $I_W$ aufgeteilt werden. In gleicher Weise kann der Strom durch die Teilströme in komplexen statorfesten Koordinatensystem $I\alpha$ und $I_\beta$ ausgedrückt werden. Die Relation zwischen $I_\alpha$, $I_\beta$ und $I_U$, $I_V$ und $I_W$ sind bereits weiter oben angegeben worden. Unter Verwendung der komplexen Darstellung $I_\alpha$ und $I_\beta$, die die ortsfesten Statorachsenrichtungen angeben und den drei Strangströmen $I_U$, $I_V$ und $I_W$ können die obige Transformationsvorschrift hergeleitet werden. Der Rotor besitzt ein drehendes Koordinatensystem d/q, das die Rotor-Flussachse d und Querflussachse q aufweist. Der Zusammenhang zwischen den sich drehenden Koordinaten d/q und den ortsfesten Koordinaten $\alpha/\beta$ kann durch den Rotordrehwinkel $\beta_k$ hergestellt werden.

In Fig. 3 ist schematisch der Aufbau eines Drehstrom-Asynchronmotors 09 dargestellt. Dieser umfasst in einer einfachen Ausführung einen dreiphasigen Stator 13 mit den Spulensträngen U1, U2 (07-U), V1, V2 (07-V) und W1, W2 (07-W). Die ortsfesten Statorspulen definieren drei Spulenachsen A1, A2 und A3, die den in Fig. 2 gezeigten drei Phasenachsen 1, $e^{j2\pi/3}$ und $e^{j4\pi/3}$ entsprechen. Der Rotor 11 umfasst einen Kurzschlussläufer, in dem bei einem sich drehenden Statormagnetfeld Spannung induziert wird, und dessen induzierter Strom ein Gegenmagnetfeld erzeugt, wodurch ein Drehmoment des Motors 09 erzeugt wird.

Schließlich zeigt Fig. 4 das Ersatzschaltbild der Verkopplung von Stator- und Rotorspulen mit den Strangströmen $I_1$, $I_2$ und $U_1$, $U_2$ wobei der Index 1 für die Statorspule und der Index 2 für die Rotorspule steht. Das Ersatzschaltbild nach Fig. 4 ist ein T-Ersatzschaltbild und beschreibt den elektrischen Zusammenhang zwischen Statorspule 01 mit $R_1$, $L_{1\sigma}$ 03, 05 und Hauptinduktivität $L_h$ zum Rotor 11 und die Wirkung der Rotorspule mit $R'_2$ und $L'_{2\sigma}$ sowie ebenfalls mit Hauptinduktivität $L_h$. Es kann folgende Admittanzfunktion hergeleitet werden:

$$G_\beta(j\omega) = \frac{I_{1\beta}(j\omega)}{U_{1\beta}(j\omega)} \, .$$

Aufgabe der vorliegenden Erfindung ist es nun, aus einem Frequenzgang der im Zeitbereich gemessenen Werte der Übertragungsfunktion unter Vorgabe eines in die $\alpha$ -Achse eingespeisten Konstantspannung und in die $\beta$-Achse eingespeisten Testsignals eine Identifikation des Massenträgheitsmoments $J$ zu ermöglichen. Hierbei kann unter Kenntnis der in Fig. 4 dargelegten Ersatzschaltbildgrößen $R_1$, $R'_2$, $L_{1\sigma}$, $L'_{2\sigma}$, und $L_h$, der Polpaarzahl $p$ und der DC-Stromstärke $I_{DC}$ die Koeffizienten der Übertragungsfunktion $G_\beta$ durch eine Parameterbestimmungsverfahren abgeleitet werden. Die koeffizientenbestimmenden Parameter dienen zur Identifikation des Massenträgheitsmoments $J$. Ausgehend von der Kenntnis des Massenträgheitsmoments $J$ kann die Rotordynamik kann bei eingespeisten Spannungen $U_\alpha$, $U_\beta$ vorhergesagt werden, wobei gewünschte Drehzahlen und Drehmomente durch Einstellung der Regelparameter optimiert werden können. Wesentlich dabei ist eine Beschreibung des transienten Verhaltens, wobei eine einzige Analyse des elektrischen Verhaltens des Motors exakte Kenntnis über die mechanischen Parameter während dynamischer Vorgänge ermöglicht.

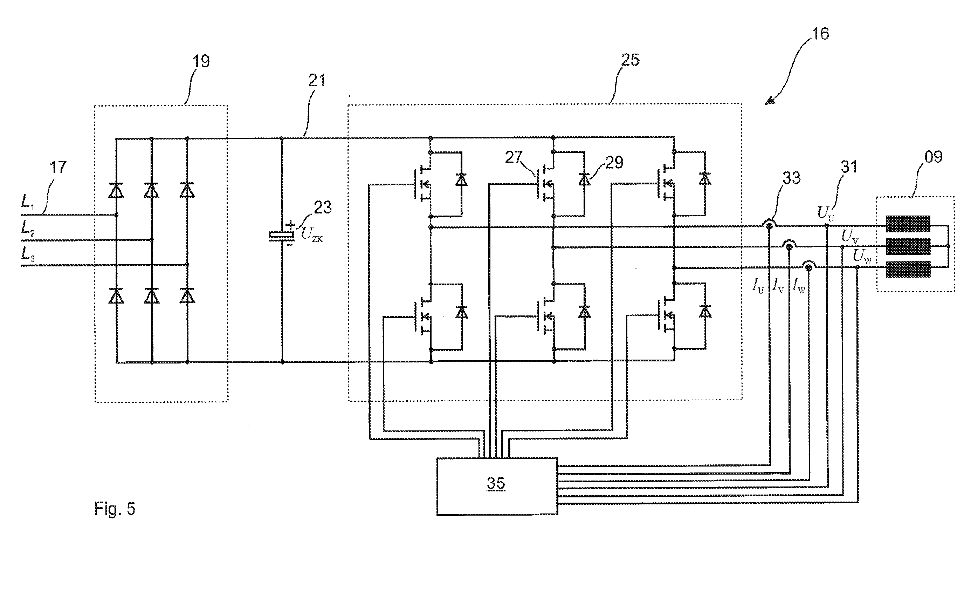

Fig. 5 zeigt schematisch eine Motoransteuerschaltung 16, bei der die Phasen eines Drehstromversorgungsnetzes 17 mittels eines Dreiphasen-Brückengleichrichters 19 in eine Gleichspannung eines DC-Zwischenkreises 21 umgewandelt werden. Im DC-Zwischenkreis 21 ist ein Pufferkondensator 23 vorgesehen, der die Spannung glättet und beispielsweise bei Stromausfall Pufferenergie für einen geregelten Notfahrbetrieb des Motors 09 zur Verfügung stellen kann. Ein Wechselrichter 25 umfasst drei Schaltbrücken, in denen Leistungshalbleiter-Schaltelemente 27 die Motorstränge *U/V/W* gegenüber der Gleichspannung +DC und -DC des Zwischenkreises 21 koordiniert schalten können, und somit drehzahlvariabel eine PWM-modellierte Ansteuerspannung $U_u$, $U_v$, $U_w$ für den Drehstrommotor 09 bereitstellen. Jedes Leistungshalbleiterschaltelement 27, das ein IGBT-Transistor, ein Leistungstransistor oder Ähnliches umfassen kann, ist mittels einer Freilaufdiode 29 gegen Überspannung, insbesondere induktive Rückwirkung durch den Motor 09, geschützt. Die Strangspannungen $U_u$, $U_v$, $U_w$ 31 sowie Strangströme $I_u$, $I_v$, $I_w$ 33 werden in den Zuführleitungen zu dem Drehstrommotor 09 abgegriffen, und einer Motorsteuerungsvorrichtung 35 zugeführt. Die Strangspannungen müssen nicht notwendigerweise abgegriffen werden, da diese vom Wechselrichter 25 vorgegeben werden können und angenommen wird, dass der Spannungssollwert gleich dem Spannungsistwert ist.

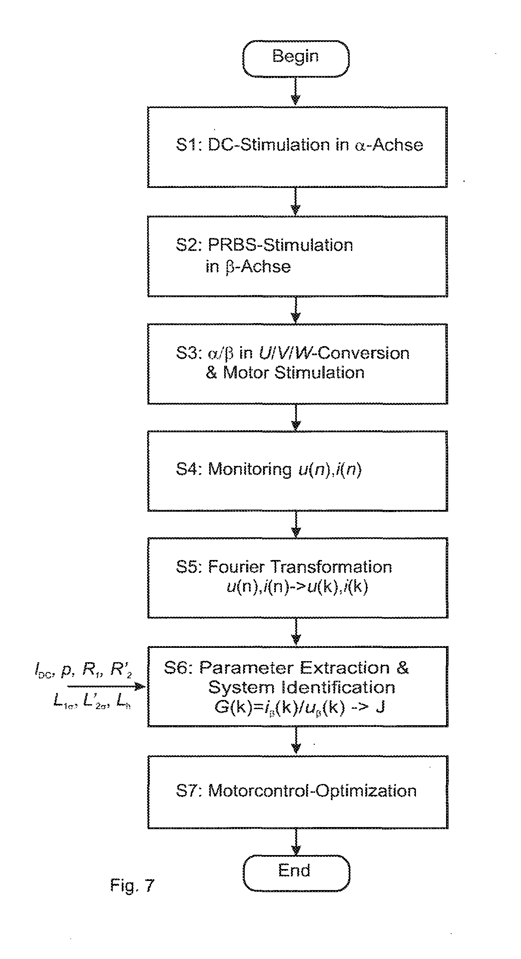

Die Motorsteuerungsvorrichtung 35 umfasst Steuerleitungen, um die einzelnen Leistungshalbleiterschaltelemente 27 je nach gewünschtem Drehzahlverhalten des Motors 09 phasenrichtig anzusteuern. Im Falle einer sensorbasierten Regelung ist die Motorsteuerungsvorrichtung 35 des Weiteren mit Positionswinkel- und Beschleunigungssensoren gekoppelt, wobei auch Temperatursensoren zur Überwachung der Betriebstemperatur des Motors 09 angeschlossen werden können. Im Falle einer drehgeberlosen feldorientierten Regelung kann die Motorsteuerungsvorrichtung 35 lediglich durch Kenntnis der Strangspannungen 31 und gemessenen Strangströmen 33 eine drehzahloptimierte Ansteuerung der Wechselrichter-Schaltbauteile 27 vornehmen. Die Regelparameter der Motorsteuerungsvorrichtung 35 können durch Kenntnis des Dynamikverhaltens des Motors 09, der sich durch das in Fig. 4 dargestellte Ersatzschaltbild beschreiben lässt, eingestellt werden. Hierzu umfasst die Motorsteuerungsvorrichtung 35 eine Identifikationseinrichtung 39, wie sie in Fig. 7 dargestellt ist.

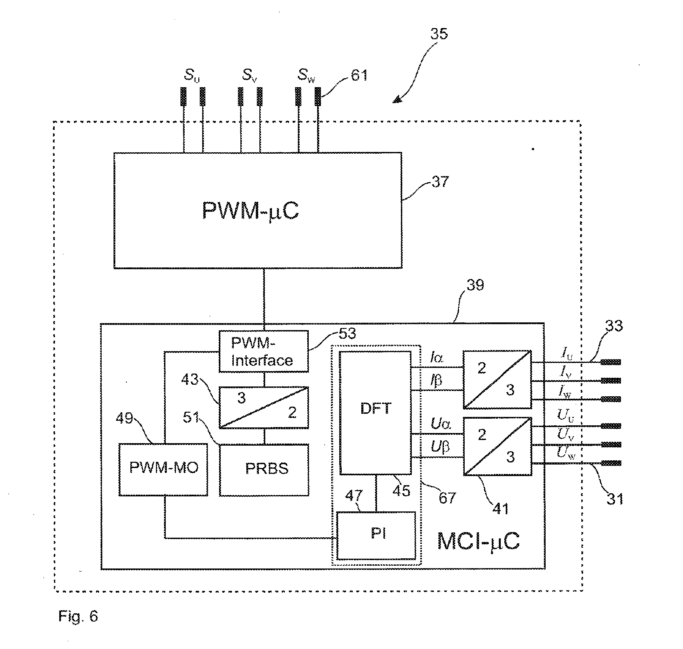

In der Fig. 6 ist ein Ausführungsbeispiel einer Motorsteuerungsvorrichtung 35 dargestellt, die eine Identifikationseinrichtung 39 zur Extraktion mechanischer Kenngrößen des Drehstrom-Asynchronmotors 09 umfasst. Die Motorsteuerungsvorrichtung 35 weist Eingänge zur Erfassung der drei Strangströme $I_U$, $I_V$ und $I_W$ 33 sowie der drei Strangspannungen $U_U$, $U_V$ und $U_W$ 31 des Drehstrommotors 09 auf, wobei eine Erfassung von nur zwei Strangspannungen und Strangströmen genügt, da sich die dritte Größe nach Kirchhoff ergibt. Des Weiteren umfasst die Motorsteuerungsvorrichtung 35 Schaltausgänge 61 zur Ausgabe von Wechselrichter-Schaltsignalen für eine Betätigung der Leistungshalbleiter-Schaltelemente 27 des Wechselrichters 25. Die phasenrichtige Erzeugung der Wechselrichter-Schaltsignale 61 erfolgt mittels eines PWM (Pulse-Width Modulation)-Mikrocontrollers, der eine Wechselrichter-Steuereinrichtung 37 darstellt, um sensorlos oder auch sensorgestützt eine Drehzahl- und Drehmomentregelung des Drehstrommotors 09 vorzunehmen. Die Identifikationseinrichtung 39 empfängt die Strangspannungen 31 und Strangströme 33 und umfasst eine α/β-Transformationseinheit 41, die Strangspannungen und Strangströme in die Teilspannung $U_\alpha$, $U_\beta$ sowie Teilströme $I_\alpha$, $I_\beta$ des komplexen Zweikoordinatensystems umwandelt. Die umgewandelten Strangspannungen und Strangströme werden in eine Parameteridentifikationseinheit 67 eingespeist, die zum einen ein Fouriertransformationsmittel 45 und zum anderen ein Parameterextraktionsmittel 47 umfasst. Auf die Zeitbereichsdaten der Strangspannungen und Strangströme wird eine Fouriertransformation angewendet, so dass diese Daten im Frequenzbereich vorliegen und oben definierte Admittanz-Übertragungsfunktionen $G_\beta$ gebildet werden kann. Anstelle der Admittanzfunktion können Parameter einer anderen Übertragungsfunktion, insbesondere Impedanzfunktion oder andere sinnvolle elektrische Funktionsbeziehungen zugrunde gelegt und deren Parameter bestimmt werden. Ausgehend von den Verläufen der Übertragungsfunktionen kann die Parameteridentifikationseinheit 67 des Parameterextraktionsmittels 47 unter Kenntnis der zugrunde liegenden Admittanz-Beschreibungsfunktion die zu identifizierende Parameter aus den Kurvenverläufen extrahieren. Hierzu können Ersatzschaltbildparameter $R_1$, $R'_2$, $L_{1\sigma}$, $L'_{2\sigma}$ und $L_h$ des in Fig. 4 dargestellten Ersatzschaltbilds einfließen, die zuvor durch ein verwandtes Verfahren oder durch klassische Kurzschluss-, Gleichstrom und Leerlauf-Messungen ermittelt worden sind. Unter Kenntnis der mechanischen Kenngrößen kann eine Optimierungseinheit 49, die eine Modulierung des Motors sowie eine Optimierung von Parametereinstellungen der Pulsweitenerzeugung vornehmen kann, Steuerparameter sowie Filterparameter für die Parametrierung, Optimierung und Überwachung der Wechselrichter-Steuereinrichtung 37 erzeugen. Diese werden an ein PWM-Interface 53 weitergeleitet und können an die Wechselrichter-Steuereinrichtung 37 übermittelt werden, um eine optimale Regelung des Asynchronmotors zu ermöglichen.

Im Rahmen der Parameterextraktion wird ein Testsignal in die β-Statorachse und eine Gleichspannung in die α-Achse eingespeist, die über eine Testsignalerzeugungseinheit 51 generiert werden können. In diesem Ausführungsbeispiel wird als Testsignal ein Pseudo-Rausch-Binär-Signal (PRBS) erzeugt, das mittels einer *U/V/W*-Transformationseinheit 43 das Rauschsignal als $U_\beta$ bereitstellt und auf die drei Strangspannungen $U_U$, $U_V$ und $U_W$ verteilt. Dieses Testsignal wird an die Wechselrichter-Steuereinrichtung 37 weitergeleitet, die entsprechend den Wechselrichter 25 so steuert, dass der Motor 09 entsprechend dem Testsignal bestromt wird.

In der Fig. 7 ist ein Ausführungsbeispiel eines Programmablaufplans zur Durchführung eines erfindungsgemäßen Verfahrens dargestellt. In Schritt S1 wird zunächst in die $\alpha$-Achse des Rotors eine Gleichspannung $U_{1\alpha}$ eingespeist. In Schritt S2 wird die Einspeisung eines Testsignals als PRB-Signal in die $\beta$-Achse vorgenommen. Aus dem $\beta$-Testsignal und der $\alpha$-Gleichspannung wird eine Konversion in die Strangspannungen $U_U$, $U_V$ und $U_W$ durchgeführt und damit der Motor angesteuert. Die angesteuerten Spannungssignale $U(n)$ sowie die gemessenen Stromwerte $I(n)$ werden im Zeitbereich abgetastet und mittels einer Fouriertransformation, insbesondere einer DFT (Diskreten Fourier Transformation) oder FFT (Fast Fourier Transformation) unter Verwendung einer Welch-Methode, in den Frequenzbereich, d.h. in diesem Fall in den Laplace-Bereich überführt, so dass sich die Frequenzbereichswerte $U(k)$, $I(k)$ ergeben. Im Laplace-Bereich kann eine Übertragungsfunktion der Admittanz dargestellt werden als

$$G_\beta(k) = I_\beta(k)/U_\beta(k),$$

die die Ausgangsbasis für die Parameterextraktion bildet. Unter Kenntnis der Übertragungsfunktion, der Ersatzschaltbildparameter $R_1$, $R_2$, $L_{1\alpha}$, $L'_{2\sigma}$ und $L_h$, der Polpaarzahl $p$ und der Größe des DC-Stroms der $\alpha$-Achse kann mittels einer Systemidentifikation eine Parameterextraktion, beispielsweise aufbauend auf den Levenberg-Marquardt-Algorithmus durchgeführt werden, um die Übertragungsfunktions-Koeffizienten $a_0$, $a_1$, $a_2$, $b_0$, $b_1$, $b_2$, und $b_3$ aus dem Kurvenverlauf zu ermitteln. Hieraus kann der Wert des Parameters $k$ und somit das Massenträgheitsmoment des Antriebsstrangs $J$ abgeleitet werden, und zur Einstellung von Motorsteuerungsparametern, zur Optimierung von Lastwechseln oder Drehmomentwechseln und/oder zur Einstellung und Auslegung von Filterparametern für ein Filtern von Motorströmen oder Motorspannungen herangezogen werden. Durch die Kenntnis der Dynamikgrößen des Antriebsstrangs kann eine Parametrierung der Wechselrichter-Steuereinrichtung 37 vorgenommen werden, wobei eine hohe Dynamik des Motorverhaltens durch Optimierung des Regelverhaltens der Wechselrichter-Steuereinrichtung als innerster Regler erreicht werden kann. Dabei können anspruchsvolle Regelungsverfahren, die weit über die Möglichkeiten eines konventionellen PI-Reglers des Asynchronmotors hinausgehen, erreicht werden, da eine präzise Kenntnis der mechanischen Maschinenparameter vorliegt. Insbesondere können die Reglerparameter für einen Zustandsraumregler, einen Dead-Beat-Regler oder einer Modellfolgeregerung exakt eingestellt werden.

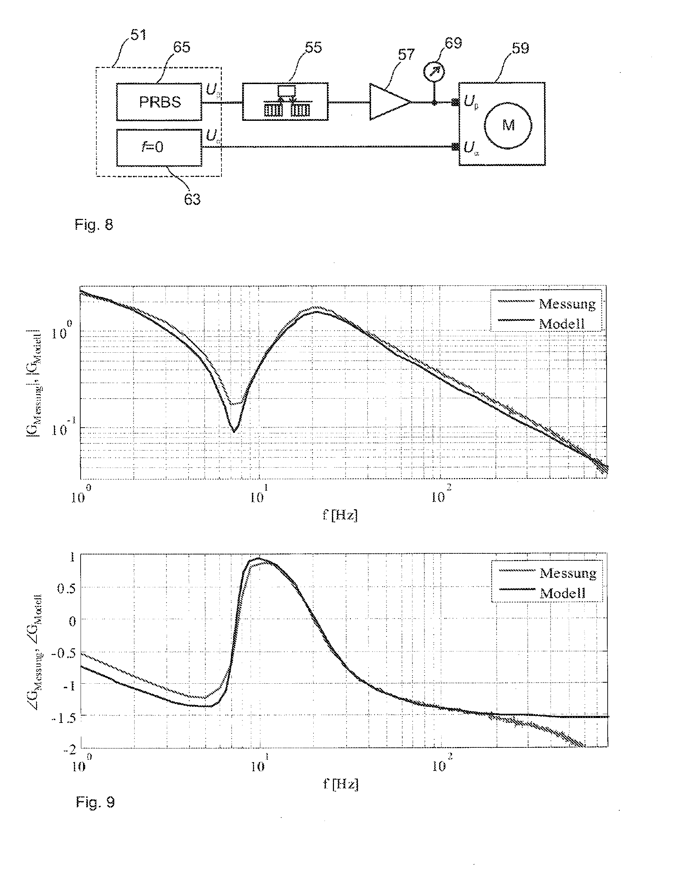

In der Fig. 8 ist schematisch die Einspeisung eines Testsignals einer Testsignal-Erzeugungseinheit 51 in ein mathematisches Modell eines Drehstrommotors 59 als $\alpha/\beta$-Modell im Rahmen einer Matlab-Simulink Simulation dargestellt. Hierzu umfasst die Testsignalerzeugungseinheit 51 ein $\alpha$-Testsignalerzeugungsmittel 63 und $\beta$-Testsignalerzeugungtmittel 65. Das $\beta$-Testsignalerzeugungsmittel 65 erzeugt ein Pseudo-Rausch-Binär-Signal, das mit einer typischen Taktfrequenz einer Wechselrichter-Steuerungseinrichtung 37 mit 16 kHz bereitgestellt wird und mittels einer Abtastratenerhöhungseinheit 55 auf ein quasi zeitkontinuierliches Signal umgewandelt wird, wobei eine Verstärkung des Signals mittels eines Testsignalverstärkers 57 nachgeschaltet ist. Den zeitlichen Verlauf des Testsignals und des Signalstroms $I_\beta$ wird mittels einer Signalaufzeichnungseinheit 69 erfasst. Das PRB-Signal wird als Spannung $U_\beta$ in das mathematische Modell des Drehstrommotors 59 eingespeist. Parallel hierzu erzeugt das $\alpha$-Testsignalerzeugungsmittel 63 eine Konstantspannung, die als $U_\alpha$ in das Modell des Drehstrommotors 59 eingespeist wird, und die einen Konstantstrom $I_\alpha = I_{DC}$ erzeugt.

In Fig. 9 ist ein Betrags- und Phasenvenauf über einen Frequenzbereich von 0-1 kHz der Admittanz-Funktion $G_\beta = \underline{Y}$ dargestellt, die aus einem gemessenen Maschinenmodell und aus dem exakten Maschinenmodell gewonnen wurde. Deutlich ist zu erkennen, dass die Übertragungsfunktion $G_\beta$ nahezu identisch mit dem exakten Maschinenmodell übereinstimmen. Somit kann mittels numerischer Simulation eine Verifikation des theoretischen Modells nachgewiesen werden. Ausgehend von dem im Zeitbereich gemessenen abgetasteten Strangspannungen und Strangströmen kann eine nahezu identische Systemcharakterisierung des mechanischen Verhaltens des Drehstrommotors 09 abgeleitet werden.

Mit obiger mathematischen Betrachtung ist es gelungen, eine geschlossene analytische Beschreibung der gemessenen Kurve herzuleiten. Die Messung der Kurve gelingt ausschließlich aus elektrischen Größen, liefert jedoch außerdem die gesuchte Information über dass Massenträgheitsmoment des Asynchronmotors, die gemäß (Gl. 3) im Term für $k$ enthalten ist. Dabei beruht die grundsätzliche Idee der Erfindung auf einer signaltheoretischen Betrachtung eines Drehstrom-Elektromotors in einem Zweikoordinatenraum $\alpha/\beta$, wobei unter Konstanthestromung der $\alpha$-Achse mittels einseitiger Einspeisung eines breitbandigen Testsignals, bevorzugt eines PRB-Signals, als Motorspannung $U_\beta$, ein Auswertesignal, das als Motorstrom $I_\beta$ vorliegt, in den Frequenzbereich mittels bevorzugt eines Welch-Verfahrens transformiert werden kann. Aufbauend darauf kann eine Übertragungsfunktion $G_\beta$ aus dem eingespeisten und gemessenen Signal extrahiert werden und mittels einer Parameteridentifikationsmethode, bevorzugt einem Levenberg-Marquardt Algorithmus, die zugrunde liegenden Systembeschreibungsparameter ausgewertet werden. Durch Kenntnis des formelmäßigen Zusammenhangs der Übertragungsfunktionen können die einzelnen Funktionsparameter identifiziert und damit das mechanische Dynamikverhalten des Motors charakterisiert werden. Besonderen Schwerpunkt legt die Erfindung auf die besondere Einspeisungsart, die Struktur der Übertragungsfunktion und die Analysevorschrift, bei der der Rotor freie Dreh- oder Pendelbewegungen zur Bestimmung des Massenträgheitsmoments ausführen kann. Das Verfahren bildet das Dynamikverhalten des Motors über einen großen Arbeitsfrequenzbrereich bzw. Drehzahlbereich ab und kann zur Einstellung, Optimierung und Überwachung des Motors verwendet werden. Insbesondere bei Einsatz in einer Motorsteuerungsvorrichtung kann eine universelle Motorsteuerungsvorrichtung bereitgestellt werden, die adaptiv werksseitig oder nach Einbau des Motors bei Verkopplung mit einem mechanischen Abtriebsstrang zur Bestimmung des Motorverhaltens benutzt werden kann. Eine motorschonende und schnelle Bestimmung der maschinenbeschreibenden Parameter wird dadurch ermöglicht. Das Verfahren kann softwaretechnisch in bestehenden Motorsteuerungsvorrichtungen wie beispielsweise den Baumüller b_maXX-Motorsteuerungen und Servoregler, insbesondere b_maXX 1000-5000 nachgerüstet werden und eröffnet eine automatisierte Identifikation und Überwachung der motorbeschreibenden Parameter.

**Bezugszeichenliste**

| 01 | Statorspulen-Ersatzschaltbild eines Asynchronmotors |
|---|---|
| 03 | Spulenwiderstand |
| 05 | Spuleninduktivität |
| 07 | U/V/W-Spulenstrang |
| 09 | Asynchronmotor |
| 11 | Rotor |
| 13 | Stator |
| 15 | Ersatzschaltbild einer Ständerspule eines Asynchronmotors |
| 16 | Motoransteuerschaltung |
| 17 | AC-Versorgungsnetz |
| 19 | Dreiphasen-Brückgleichrichter |
| 21 | DC-Zwischenkreis |
| 23 | Pufferkondensator |
| 25 | Wechselrichter |
| 27 | Leistungshalbleiter-Schaltelement |
| 29 | Freilaufdiode |
| 31 | Strangspannung |
| 33 | Strangstrom |
| 35 | Motorsteuerungsvorrichtung |
| 37 | Wechselrichter-Steuereinrichtung |
| 39 | Identifikationseinrichtung |
| 41 | $\alpha/\beta$-Transformationseinheit |

43 *U/V/W*-Transformationseinheit

45 Fouriertransformationsmittel

47 Parameterbestimmungsmittel

49 Optimierungseinheit

51 Testsignal-Erzeugungseinheit

53 Wechselrichtersteuerungs-Interfaceeinheit

55 Abtastratenerhöhungseinheit

57 Testsignalverstärker

59 $\alpha/\beta$-Asynchronmotor-Modell

61 Wechselrichter-Schaltsignale

63 $\alpha$-Testsignal-Erzeugungsmittel

65 $\beta$-Testsignal-Erzeugungsmittel

67 Parameteridentifikationseinheit

69 Signalaufzeichnungseinheit

**Patentansprüche**

1. Verfahren zur drehgeberlosen Identifikation mechanischer Kenngrößen, insbesondere Massenträgheitsmoment ($J$) eines Drehstrom-Asynchronmotors (09), **dadurch gekennzeichnet, dass** es zumindest umfasst die Schritte:

- Konstantspannungseinprägung ($U_{1\alpha}$) in $\alpha$-Achsenrichtung, mit $\alpha$- und $\beta$-Koordinaten bezüglich der ortsfesten Ausrichtung der Statorwicklungen, zur Erzeugung eines Konstantmagnetflusses;
- Testsignalspannungseinspeisung ($U_{1\beta}$) in $\beta$-Achsenrichtung des Asynchronmotors (09), wobei die $\alpha$-Achsenrichtung konstant bestromt bleibt;
- Meßsignalstrommessung ($I_{1\beta}$) in $\beta$-Statorachsenrichtung des Asynchronmotors (09);
- Identifikation von mechanischen Kenngrößen des Asynchronmotors (09) auf Basis der digital erfassten zeitlichen Abtastwerte der Testsignalspannung ($U_{1\beta}$) und des Meßsignalstroms ($I_{1\beta}$) durch Analyse des Frequenzgangs der gemessenen Übertragungsfunktion unter Kenntnis der Übertragungsfunktion im Frequenzbereich eines Ersatzschaltbildes eines Asynchronmotors mittels Parameterextraktion;
wobei die Testsignaleinspeisung in den Asynchronmotor (09) derart erfolgt, dass der Rotor (11) aufgrund der Testsignaleinspeisung Auslenkungsbewegungen (75) ausführen kann.

2. Verfahren nach einem der vorangegangenen Ansprüche,
**dadurch gekennzeichnet,**
**dass** das Verhältnis von Konstantspannung ($U_{1\alpha}$) zur Testsignalspannung ($U_{1\beta}$) derart optimiert wählbar ist, um Auslenkungsbewegung (75) in einer Höhe zu erreichen, so dass die mechanischen Kenngrößen (79) mit einer vorbestimmbaren Genauigkeit ermittelt werden können.

3. Verfahren nach Anspruch 1 oder 2,
**dadurch gekennzeichnet,**
**dass** zur identifikation der mechanischen Kenngrößen weitere Größen, insbesondere Ersatzschaftbildkenngrößen (03, 05, 15) sowie mechanische Strukturgrößen wie Polpaarzahl und/oder elektrische Meßgrößen wie $I_{1\alpha}=I_{DC}$ berücksichtig oder ebenfalls identifiziert werden.

4. Verfahren nach einem der vorangegangene Ansprüche,
**dadurch gekennzeichnet,**
**dass** das Testsignal ein pseudo-Rausch-Binär-Signal ist.

5. Verfahren nach einem der vorangegangenen Ansprüche,
**dadurch gekennzeichnet,**
**dass** die Identifikation der mechanischen Kenngrößen eine Fouriertransformation von zeitdiskreten Signalen nach einem Welch-Verfahren umfasst.

6. Verfahren nach einem der vorangegangenen Ansprüche,
**dadurch gekennzeichnet,**
**dass** die identifikation der mechanischen Kenngrößen eine Ü-bertragungsfunktion-Parameterbestimmung insbesondere nach einem Levenberg-Marquardt-Algorithmus umfasst.

7. Verfahren nach einem der vorangegangenen Ansprüche,
**dadurch gekennzeichnet,**
**dass** die identifizierten mechanischen Kenngrößen bei einer Einstellung und/oder Optimierung von Wechseirichter-Steuerparametern und/oder zur Motorüberwachung verwendet werden.

8. Identifikationseinrichtung (39) zur drehgeberlosen Identifikation mechanischer Kenngrößen, insbesondere Massenträgheitsmoment ($J$) des Rotors (11) eines Drehstrom-Asynchronmotors (09), der von einer eine Wechselrichter-Steuereinrichtung (37) enthaltenden Steuerung (35) gesteuert ist,
**gekennzeichnet dadurch,**
**dass** die Identifikationseinrichtung (39)

 - eine Wechselrichter-Interfaceeinheit (53), die zur steuernden Kommunikation und zur Rotorpositionsbestimmung mit der Wechselrichter-Steuereinrichtung (37) verbindbar ist, und zur Konstantspannungseinprägung ($U_{1\alpha}$) in $\alpha$-Achsenrichtung, mit $\alpha$- und $\beta$-Koordinaten bezüglich der ortsfesten Ausrichtung der Statorwicklungen, zur Erzeugung eines Konstantmagnetflusses dient,
 - des Weiteren eine Testsignalerzeugungseinrichtung (51) zur Erzeugung eines $\alpha/\beta$-Testsignals in Form der Testsignalspannung ($U_{1\beta}$) zur Testsignalspannungseinspeisung ($U_{1\beta}$) in $\beta$-Achsenrichtung des Asynchronmotors (09), wobei die $\alpha$-Achsenrichtung konstant bestromt bleibt, wobei die Testsignaleinspeisung in den Asynchronmotor (09) derart erfolgt, dass der Rotor (11) aufgrund der Testsignaleinspeisung Auslenkungsbewegungen (75) ausführen kann,
 - eine $U/V/W$-Transformationseinheit (43) zur Transformation des $\alpha/\beta$-Testsignals in ein dem Motor (09) zugeführtes $U/V/W$-Steuertestsignal,
 - eine $\alpha/\beta$ Transformationseinheit (41) zur Transformation gemessener $U/V/W$-Meßsignalsströme in $\alpha/\beta$ Meßsignalsströme ($I_{1\beta}$) zur Meßsignalstrommessung ($I_{1\beta}$) in $\beta$-Statorachsenrichtung des Asynchronmotors (09)
 - und eine Parameteridentifikationseinheit (67) zur Identifikation der mechanischen Kenngrößen auf Basis der Testsignalspannung ($U_{1\beta}$) und des Meßsignalstroms ($I_{1\beta}$) durch Analyse des Frequenzgangs der gemessenen Übertragungsfunktion unter Kenntnis der Übertragungsfunktion im Frequenzbereich eines Ersatzschaltbildes eines Asynchronmotors mittels Parameterextraktion, umfasst.

9. Einrichtung nach Anspruch 8,
**dadurch gekennzeichnet,**
**dass** die Parameteridentifikationseinheit (67) ein Fouriertransformationsmittel (45), insbesondere ein FFT/DFT-Mittel zur Fouriertransformation diskontinuierlicher $\alpha/\beta$-Signalwerte nach dem Welch-Verfahren, und ein Parameterbestimmungsmittel (47), insbesondere ein Levenberg-Marquardt-Übertragungsfunktions-Parameterbestimmungsmittel, umfasst.

10. Einrichtung nach einem der Ansprüche 8 oder 9,
**dadurch gekennzeichnet,**
**dass** des Weiteren eine Überwachungs- und Optimierungseinheit (49) umfasst ist, die eingerichtet ist, auf Basis der identifizierten mechanischen Kenngrößen Steuerparameter einer Wechselrichter-Steuereinrichtung (37) zu bestimmen, zu optimieren und/oder zu überwachen.

11. Motorsteuerungsvorrichtung (35) zur drehgeberlosen Steuerung eines Drehstrom-Asynchronmotors (09)
**gekennzeichnet dadurch,**

**dass** eine Identifikationseinrichtung (39) zur drehgeberlosen Identifikation mechanischer Kenngrößen eines Drehstrom-Asynchronmotors (09) nach einem der vorgenannten Ansprüche 8 bis 10 umfasst ist, wobei die identifizierten Kenngrößen zur Bestimmung, Optimierung und Überwachung der Motorsteuerung verwendbar sind.

**12.** Vorrichtung nach Anspruch 11,
**dadurch gekennzeichnet,**
**dass** die Vorrichtung dergestalt eingerichtet ist, dass zumindest bei der erstmaligen Inbetriebnahme, bevorzugt mehrmals im Laufe des Betriebslebens eine automatisierte Identifikation der mechanischen Kenngrößen vornehmbar ist, wobei bei einer voreinstellbaren Abweichung der mechanischen Kenngrößen von zuvor bestimmten, gespeicherten und/oder modellbezogenen Kenngrößen eine Fehlersignalisierung auslösbar ist.

**13.** Verwendung eines Verfahrens nach einem der vorangegangenen Verfahrensansprüche zur Bestimmung, Optimierung und Überwachung von Motorreglerparametern für die Steuerung elektrischer Antriebe, insbesondere zur Einstellung von Reglerparametern einer Motorsteuerungsvorrichtung (35).

**Claims**

1.  A method for the identification without shaft encoder of mechanical characteristic quantities, in particular mass moments of inertia ($J$) of a three-phase asynchronous motor (09) **characterized in that**
    comprising at least the steps:

    - impressing a constant voltage ($U_{1\alpha}$) in $\alpha$ axial direction, with $\alpha$- and $\beta$ - coordinates with respect to the fixed orientation of the stator windings, in order to generate a constant magnetic flux;
    - supplying a test signal voltage ($U_{1\beta}$) in $\beta$- axis direction of the asynchronous motor (09), wherein the $\alpha$- axis direction remains supplied with constant current;
    - measuring of measuring signal current ($I_{1\beta}$) in $\beta$ stator axial direction of the asynchronous motor (09);
    - identifying mechanical characteristic quantities of the asynchronous motor (09) based on the digitally recorded time samples of the test signal voltage ($U_{1\beta}$) and on the measuring signal current ($I_{1\beta}$) by analysis of the frequency response of the measured transfer function with knowledge of the transfer function in the frequency range of an equivalent circuit of an asynchronous motor by means of parameter extraction;

    wherein the supplying of a test signal into the asynchronous motor (09) takes place such that the rotor (11) can execute deflection movements (75) based on the supplying of test signals.

2.  The method according to one of the previous claims,
    **characterized in that**
    the ratio of constant voltage ($U_{1\alpha}$) to test signal voltage ($U_{1\beta}$) can be selected in such an optimal manner for achieving a deflection movement (75) at a height such that the mechanical characteristic quantities (79) can be determined with a pre-determinable accuracy.

3.  The method according to Claim 1 or 2,
    **characterized in that**
    for the identification of the mechanical characteristic quantities further magnitudes, in particular equivalent circuit characteristic quantities (03, 05, 15) as well as mechanical structural magnitudes such as pole pair number p and/or electrical measuring magnitudes such as $I_{1\alpha} = I_{DC}$ can be taken into account or also identified.

4.  The method according to one of the previous claims,
    **characterized in that**
    the test signal is a pseudo-noise binary signal.

5.  The method according to one of the previous claims,
    **characterized in that**
    the identification of the mechanical circuit parameters comprises a Fourier transformation of time-discrete signals according to a Welch method.

6.  The method according to one of the previous claims,
    **characterized in that**

the identification of the mechanical characteristic quantities comprises a transmission function determination of parameters, in particular according to a Levenberg-Marquardt algorithm.

7. The method according to one of the previous claims,
**characterized in that**
the identified mechanical characteristic quantities are used in an adjustment and/or optimization of inverter control parameters and/or for motor monitoring.

8. An identification apparatus (39) for the identification without shaft encoder of mechanical characteristic quantities, in particular mass moment of inertia ($J$) of the rotor (11) of a three-phase asynchronous motor (09), which is controlled by a control device (35), which contains an inverter control device (37),
**characterized in that**
the identification apparatus (39) comprising:

- an inverter interface unit (53) that is connected to an inverter control device (37) for controlling communication and for determination of the rotor position, and which serves for the constant voltage supply ($U_{1\alpha}$) in $\alpha$-axis direction, with $\alpha$- coordinates and $\beta$- coordinates with respect to the fixed orientation of the stator windings, for generating a constant magnetic flux,
- furthermore a test signal generation apparatus (51) for generating an $\alpha/\beta$ test signal in terms of the test signal voltage ($U_{1\beta}$) for the test signal supply ($U_{1\beta}$) in $\beta$- axial direction of the asynchronous motor (09), wherein the $\alpha$- axial direction remains constantly supplied with current, wherein the test signal injection to the asynchronous motor (09) takes place such that the rotor (11) is able to perform deflection movements (75) due to the test signal supply,
- an U/V/W transformation unit (43) for transforming the $\alpha/\beta$ test signal into an U/V/W control test signal, which is supplied to the motor (09),
- an $\alpha/\beta$ transformation unit (41) for transforming measured U/V/W measuring signal currents into $\alpha/\beta$ measuring signal currents ($I_{1\beta}$) for measuring of the measuring signal current ($I_{1\beta}$) in $\beta$- stator axis direction of the asynchronous motor (09)
- and a parameter identification unit (67) for identifying the mechanical characteristic quantities based on the test signal voltage ($U_{1\beta}$) and the measuring signal current ($I_{1\beta}$) by analysis of the frequency response of the measured transfer function with knowledge of the transfer function in the frequency range of an equivalent circuit of an asynchronous motor by means of parameter extraction.

9. The apparatus according to Claim 8,
**characterized in that**
the parameter identification unit (67) comprises a Fourier transformation means (45), in particular an FFT/DFT means for the Fourier transformation of discontinuous $\alpha/\beta$ scanning signal values according to the Welch method and comprises a parameter determination means (47), in particular a Levenberg-Marquardt transmission function-parameter determination means.

10. The apparatus according to one of Claims 8 or 9,
**characterized in that**
a monitoring and optimization unit (46) is furthermore comprised that is set up to determine, optimize and/or monitor control parameters of an inverter control apparatus (37) on the basis of the mechanical characteristic quantities.

11. A motor control device (35) for the control without shaft encoder of a three-phase asynchronous motor (09),
**characterized in that**
an identification apparatus (39) for the identification without shaft encoder of mechanical characteristic quantities of a three-phase asynchronous motor (09) is comprised by one of the previous claims 8 to 10, wherein the identified characteristic quantities can be used for the determination, optimization and monitoring of the motor control.

12. The device according to Claim 11,
**characterized in that**
the device is arranged in such a manner that an automated identification of the mechanical characteristic quantities can be performed at least during the first startup, preferably several times in the course of the service life, whereby an error signal can be initiated upon a demonstrable deviation of the mechanical characteristic quantities from previously determined, stored and/or model-related characteristic quantities.

13. The use of a method according to one of the previous method claims for determining, optimizing and monitoring motor regulator parameters for the control of electrical drives, in particular for the adjusting of regulator parameters of a motor control device (35).

**Revendications**

1. Procédé d'identification, sans capteur rotatif, de caractéristiques mécaniques, en particulier du moment d'inertie de masse ($J$) d'un moteur asynchrone triphasé (09),
   **caractérisé en ce que**
   le procédé comprend au moins les étapes suivantes :

   - application d'une tension constante ($U_{1\alpha}$) dans la direction axiale $\alpha$, dans un système de coordonnées $\alpha$ et $\beta$ par rapport à l'orientation fixe des enroulements statoriques, pour produire un flux magnétique constant ;
   - injection d'une tension de signal de test ($U_{1\beta}$) dans la direction axiale $\beta$ du moteur asynchrone (09), la direction axiale $\alpha$ restant sous courant constant ;
   - mesure du courant de signal de mesure ($I_{1\beta}$) dans la direction axiale $\beta$ du stator du moteur asynchrone (09) ;
   - identification de caractéristiques mécaniques du moteur asynchrone (09) sur la base des échantillons temporels enregistrés numériquement de la tension de signal de test ($U_{1\beta}$) et du courant de signal de mesure ($I_{1\beta}$) par analyse de la réponse en fréquence de la fonction de transfert mesurée, connaissant la fonction de transfert dans la plage de fréquence d'un circuit équivalent d'un moteur asynchrone par la technique d'extraction de paramètres ;

   l'injection du signal de test dans le moteur asynchrone (09) s'effectuant de façon telle que le rotor (11) peut exécuter des mouvements de déviation (75) sous l'effet de l'injection du signal de test.

2. Procédé selon l'une des revendications précédentes,
   **caractérisé en ce que**
   le rapport de la tension constante ($U_{1\alpha}$) à la tension de signal de test ($U_{1\beta}$) peut être choisi de façon optimisée pour obtenir un mouvement de déviation (75) d'un niveau suffisant pour que les caractéristiques mécaniques (79) puissent être déterminées avec une précision prédéterminable.

3. Procédé selon la revendication 1 ou 2,
   **caractérisé en ce que,**
   pour l'identification des caractéristiques mécaniques, d'autres grandeurs, en particulier des caractéristiques de circuits équivalents (03, 05, 15) ainsi que des grandeurs de structures mécaniques comme le nombre de paires de pôles et/ou des grandeurs de mesure électriques comme $I_{1\alpha} = I_{DC}$, sont prises en compte ou également identifiées.

4. Procédé selon l'une des revendications précédentes,
   **caractérisé en ce que**
   le signal de test est un signal binaire de pseudo-bruit.

5. Procédé selon l'une des revendications précédentes,
   **caractérisé en ce que**
   l'identification des caractéristiques mécaniques comprend une transformée de Fourier de signaux à temps discret selon un procédé Welch.

6. Procédé selon l'une des revendications précédentes,
   **caractérisé en ce que**
   l'identification des caractéristiques mécaniques comprend une détermination de paramètres par fonction de transfert, en particulier selon un algorithme de Levenberg-Marquardt.

7. Procédé selon l'une des revendications précédentes,
   **caractérisé en ce que**
   les caractéristiques mécaniques identifiées sont utilisées lors d'un réglage et/ou d'une optimisation de paramètres de commande d'onduleur et/ou pour la surveillance du moteur.

8. Dispositif d'identification (39) pour l'identification, sans capteur rotatif, de caractéristiques mécaniques, en particulier du moment d'inertie de masse (*J*) du rotor (11) d'un moteur asynchrone triphasé (09), lequel est commandé par une commande (35) comprenant un dispositif de commande d'onduleur (37),
**caractérisé en ce que**
le dispositif d'identification (39) comprend :

- une unité d'interface d'onduleur (53) qui peut être reliée au dispositif de commande d'onduleur (37) pour assurer la communication de commande et la détermination de la position du rotor, et sert à l'application d'une tension constante ($U_{1\alpha}$) dans la direction axiale $\alpha$, dans un système de coordonnées $\alpha$ et $\beta$ par rapport à l'orientation fixe des enroulements statoriques, pour produire un flux magnétique constant ;
- en outre, un dispositif de génération de signal de test (51) destiné à produire un signal de test $\alpha/\beta$ sous la forme de la tension de signal de test ($U_{1\beta}$) pour l'injection d'une tension de signal de test ($U_{1\beta}$) dans la direction axiale $\beta$ du moteur asynchrone (09), la direction axiale $\alpha$ restant sous courant constant, l'injection du signal de test dans le moteur asynchrone (09) s'effectuant de façon telle que le rotor (11) peut exécuter des mouvements de déviation (75) sous l'effet de l'injection du signal de test,
- une unité de transformation *U*/*V*/*W* (43) destinée à transformer le signal de test $\alpha/\beta$ en un signal de test de commande *U*/*V*/*W* délivré au moteur (09),
- une unité de transformation $\alpha/\beta$ (41) destinée à transformer des courants de signaux de mesure *U*/*V*/*W* mesurés en courants de signaux de mesure $\alpha/\beta$ ($I_{1\beta}$) pour la mesure de courants de signaux de mesure ($I_{1\beta}$) dans la direction axiale $\beta$ du stator du moteur asynchrone (09), et
- une unité d'identification de paramètres (67) destinée à l'identification des caractéristiques mécaniques sur la base de la tension de signal de test ($U_{1\beta}$) et du courant de signaux de mesure ($I_{1\beta}$) par analyse de la réponse en fréquence de la fonction de transfert mesurée, connaissant la fonction de transfert dans la plage de fréquence d'un circuit équivalent d'un moteur asynchrone par la technique d'extraction de paramètres.

**9.** Dispositif selon la revendication 8,
**caractérisé en ce que**
l'unité d'identification de paramètres (67) comprend un moyen de transformée de Fourier (45), en particulier un moyen FFT/DFT pour la transformée de Fourier de valeurs de signaux $\alpha/\beta$ discontinues selon le procédé de Welch, et un moyen de détermination de paramètres (47), en particulier un moyen de détermination de paramètres par fonction de transfert de Levenberg-Marquardt.

**10.** Dispositif selon l'une des revendications 8 ou 9,
**caractérisé en ce qu'**il comporte, en outre, une unité de surveillance et d'optimisation (49) qui est conçue pour déterminer, optimiser et/ou surveiller des paramètres de commande d'un dispositif de commande d'onduleur (37) sur la base des caractéristiques mécaniques identifiées.

**11.** Dispositif de commande de moteur (35) pour la commande, sans capteur rotatif, d'un moteur asynchrone triphasé (09)
**caractérisé en ce qu'**il comprend un dispositif d'identification (39) pour l'identification, sans capteur rotatif, de caractéristiques mécaniques d'un moteur asynchrone triphasé (09) selon l'une des revendications 8 à 10, les caractéristiques identifiées pouvant être utilisées pour la détermination, l'optimisation et la surveillance de la commande du moteur.

**12.** Dispositif selon la revendication 11,
**caractérisé en ce qu'**il est conçu de façon telle qu'au moins lors de la première mise en service, de préférence plusieurs fois au cours de la durée de service, peut être effectuée une identification automatisée des caractéristiques mécaniques, une signalisation de défaut pouvant être déclenchée dans le cas d'un écart préréglable entre les caractéristiques mécaniques identifiées et des caractéristiques préalablement déterminées, mémorisées et/ou modélisées.

**13.** Utilisation d'un procédé selon l'une des revendications précédentes pour la détermination, l'optimisation et la surveillance de paramètres de régulateurs de moteurs pour la commande d'entraînements électriques, en particulier pour le réglage de paramètres du régulateur d'un dispositif de commande de moteur (35).

Fig. 1

Fig. 2

Fig. 3

― Reinschrift ―

Fig. 4

Fig. 5

EP 2 421 148 B1

Fig. 6

25

Begin

S1: DC-Stimulation in α-Achse

S2: PRBS-Stimulation
in β-Achse

S3: α/β in *U*/*V*/*W*-Conversion
& Motor Stimulation

S4: Monitoring *u*(*n*),*i*(*n*)

S5: Fourier Transformation
*u*(n),*i*(n)->*u*(k),*i*(k)

$I_{DC}, p, R_1, R'_2$

$L_{1\sigma}, L'_{2\sigma}, L_h$

S6: Parameter Extraction &
System Identification
G(k)=$i_\beta$(k)/$u_\beta$(k) -> J

S7: Motorcontrol-Optimization

End

Fig. 7

Fig. 8

Fig. 9

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

• KR 20080062830 A

**In der Beschreibung aufgeführte Nicht-Patentliteratur**

• **SEBASTIAN VILIWOCK.** Identifikationsmethoden für die automatisierte inbetriebnahme und Zustandsüberwachung elektrischer Antriebe. *Dissertation,* 2007
• **S. VILLWOCK ; J. M. PACAS.** Applikation of the Welch-Method for the Identification of Two and Three Mass Systems. *IEEE Transactions on Industrial Electronics,* Januar 2008, vol. 55 (1), 457-466

• **P. SZCZIRPAK ; J. M. PACAS.** Automatic Identification of a PMSM Drive Equipped with an Output LC-IEEE Industrial Electronics. *IECON 2006, 32nd Annual Conference,* November 2006, 1143-1148